# EUROPEAN PATENT SPECIFICATION

(11) **EP 3 162 944 B1**
(45) Date of publication and mention of the grant of the patent: **04.08.2021**
(21) Application number: 16196148.7
(22) Date of filing: 28.10.2016
(51) Int. Cl.: D06F 34/28, G06F 3/041, D06F 39/14

(54) **LAUNDRY TREATING APPARATUS**
WÄSCHEBEHANDLUNGSVORRICHTUNG
APPAREIL DE TRAITEMENT DU LINGE

(30) Priority: 02.11.2015 US 201562249355 P; 05.01.2016 KR 20160001218; 01.04.2016 KR 20160040453
(43) Date of publication of application: 03.05.2017
(73) Proprietor: LG Electronics Inc., Seoul 07336 (KR)
(72) Inventor: KWON, Yongwoo, 08592 Seoul (KR); YONG, Seungji, 08592 Seoul (KR); CHEON, Kangwoon, 08592 Seoul (KR); CHOI, Jaehoon, 08592 Seoul (KR); PARK, Jungjin, 08592 Seoul (KR)
(74) Representative: Vossius & Partner Patentanwälte Rechtsanwälte mbB

(56) References cited:
- EP-A1- 2 742 843
- EP-A1- 3 040 467
- WO-A2-2010/128729
- CN-U- 204 298 638
- DE-A1-102013 001 682
- DE-U1- 20 210 707
- JP-A- H0 884 891
- KR-A- 20110 130 089
- KR-A- 20150 006 262
- KR-A- 20150 006 264
- US-A1- 2009 121 970

## Description

### BACKGROUND OF THE INVENTION

The present disclosure relates to a laundry treating apparatus having a door for opening and closing a laundry inlet of a body.

A laundry treating apparatus may include an apparatus for washing laundry, an apparatus for drying laundry, and an apparatus capable of performing washing and drying operations at the same time. In a laundry treating apparatus, the washing of laundry is a cycle of removing contaminants adhered to the laundry through the action of water and detergent, and the drying of laundry is a cycle of removing moisture contained in the laundry through a hot air supply device provided in the laundry treating apparatus.

Atypical laundry treating apparatus may include a body configured to form an appearance thereof and provided with a laundry inlet, a laundry accommodation portion provided within the body, a drive unit configured to rotate a drum constituting the laundry accommodation portion, a door configured to open and close the laundry inlet, and a control unit configured to display visual information associated with a cycle treated on the laundry treating apparatus for a user and receive the user's manipulation.

Such a typical laundry treating apparatus has been designed to perform an inherent function capable of opening and closing the laundry inlet and viewing the laundry accommodation portion. Furthermore, the control unit is typically provided on the body, and provided with a plurality of buttons or knobs for briefly displaying only predetermined cycles in an on/off manner or the like, and manipulating them.

The differentiation between a door and a control unit has been a hindrance to the simple appearance of the laundry treating apparatus, and input and output interfaces between the laundry treating apparatus and the user have been more likely to stay in a low-level manner.

As a result, studies for placing a control unit on a door, and implementing the control unit with a touch screen have been carried out. The related technologies can be also found in the Korean Patent Publication Nos. 10-2011-0130089 (published on December 5, 2011) and 10-2015-0006264 (published on January 16, 2015). However, studies on an integrated aesthetic sense for the door and touch screen as well as on a door structure capable of arousing advanced sensibility at low cost are still not entirely satisfactory.

Moreover, in order to couple a door cover to a door frame, an adhesive is typically used along with a mechanical fastening structure using a bracket, a hook or the like. However, when a door cover with a glass material is used to give high-quality feeling, it has difficulties in using such a mechanical fastening structure. Moreover, when the door cover is formed in a circular shape, it also causes difficulties in taking a correct installation position for the door frame.

Furthermore, an adhesive may be leaked during the process of coupling a door cover to a door frame through the adhesive, thereby causing the deterioration of appearance quality. In order to prevent the problem, an adhesive may be coated at an inner side of the door frame located far away from an edge portion thereof, but it may result in the deterioration of the joint strength, and has a problem of causing foreign substances to easily be infiltrated through a gap between the door cover and the door frame.

Meanwhile, in the aspect that the door has a configuration of opening and closing a laundry inlet, when a touch screen is provided on the door, moisture may be likely to be infiltrated into electronic elements constituting the touch screen. Accordingly, the sealing of the electronic elements may be a key point in the aspect of securing the reliability of driving the touch screen.

KR 2015 0006262 (A) discloses a washing machine having a touch panel placed on the door thereof.

CN 204 298 638 (U) discloses a washing machine that comprises an annular door body matched with an inner drum, an observation window arranged in the hollow-position of the door body, and hinges arranged at the edge of the door body and used for be connected with a shell body of the washing machine.

### SUMMARY OF THE INVENTION

An object of the present disclosure is to provide a door structure of a laundry treating apparatus capable of preventing the leakage of a sealant, enhancing the joint strength, and preventing foreign substances from being infiltrated through a gap between a door cover and a door frame during the coupling between the door cover and the door frame.

Another object of the present disclosure is to provide a door structure of a laundry treating apparatus capable of preventing moisture from being infiltrated into electronic elements constituting a display portion when the display portion (touch screen) is configured on a door.

Yet still another object of the present disclosure is to provide an additional structure capable of enhancing the sealing performance in a sealing structure for preventing the moisture from being infiltrated.

These objects are achieved with a laundry treating apparatus according to any one of the independent claims 1, 15, or 22. Preferred aspects are defined in the dependent claims.

The second light transmitting region may be formed with a smaller size than that of the second opening portion, and disposed within the second opening portion when the door cover is coupled to the door frame.

The second opening portion may be formed in a rectangular shape corresponding to the display module having a rectangular shape, and the second light transmitting region may be formed in a circular shape disposed to overlap within the second opening portion, and visual information may not be displayed on a portion that does not correspond to the second light transmitting region of the display module.

A touch sensor disposed to cover the second light transmitting region to sense a touch input to a sensing region containing the second light transmitting region may be adhered to a rear surface of the door cover.

The laundry treating apparatus may further include a controller configured to control whether to activate touch sensing to a region that does not correspond to the second light transmitting region within the sensing region.

The door cover may include a cover body formed of a light transmitting material; and a shield layer disposed to cover a rear surface of the cover body so as to form the non-light-transmitting region.

The first and the second light transmitting region may be a portion at which the shield layer is not disposed.

The shield layer may include a plurality of shield dots formed adjacent to the first light transmitting region, and the shield dots may be formed to decrease the density as being located closer to the first light transmitting region.

A mounting guide surrounding an outer circumference of the door cover may be formed in a protruding manner on the door frame along a circumference thereof.

The door cover may include a first edge portion formed in a round manner and a second edge portion for connecting both sides of the first edge, and the mounting guide may include a first protrusion portion extended in a round manner to correspond to the first edge portion and a second protrusion portion formed to correspond to the second edge portion to guide a mounting position when the door cover is mounted on the door frame.

The second protrusion portion may be formed at a lower side of the door frame.

The door frame may include an outer frame formed with a sealant filling groove to fill sealant for adhesion to the door cover on a front surface thereof; and an inner frame coupled to a rear side of the outer frame, and formed such that an outer circumferential portion thereof is protruded from a front surface of the outer frame during the coupling to form the mounting guide.

The sealant filling groove may include a sealant coating portion for filling sealant; and a sealant collecting portion formed at both sides of the sealant coating portion, respectively, to collect sealant leaked out of an inner and an outer side of the sealant coating portion, respectively.

The sealant filling groove may include a connecting groove portion formed to cross between the first and the second opening portion; a first groove portion connected to both end portions of the connecting groove portion, and formed to surround a circumference of the first opening portion along with the connecting groove portion; and a second groove portion connected to both end portions of the connecting groove portion, and formed to surround a circumference of the second opening portion along with the connecting groove portion.

The sealant filling groove further may include a bypass groove portion configured to connect between an arbitrary point on the connecting groove portion and an arbitrary point on the first groove portion.

The bypass groove portion may be located within a space formed by the connecting groove portion and the first groove portion.

The body may include a door accommodation portion recessed in an inward direction on an outer surface thereof to have the laundry inlet therewithin, and in a state that that the door is closed, the door may be accommodated into the door accommodation portion, and an edge portion of the outer surface of the door cover may form the same plane as that of an outer surface of the body adjacent thereto.

The sealant filling groove may further include a first sealant collecting portion formed to surround the first opening portion in an inner space formed by the connecting groove portion and the first groove portion; a second sealant collecting portion formed to surround the second opening portion in an inner space formed by the connecting groove portion and the second groove portion; and a third sealant collecting portion formed to surround the first groove portion and the second groove portion.

The laundry treating apparatus may further include a controller configured to control whether to activate touch sensing to a region that does not correspond to the light transmitting region within the sensing region.

The light transmitting region may be formed with a smaller size than that of the display, and disposed to overlap within the display module when the door cover is coupled to the door frame, and visual information may not be displayed on a portion that does not correspond to the light transmitting region within the display module.

The door frame may comprise a first mounting portion formed on a front surface of the door frame to mount the door cover; and a second mounting portion formed in a recessed shape at an inner side of the first mounting portion to mount the mounting frame. The door cover may disposed to cover the mounting frame in a state that the door cover is mounted on the door frame.

An accommodation groove formed to accommodate part of the display sealing member and surround the display, may be formed on either one of the mounting frame and the door frame.

Another part of the display sealing member may be formed to be protruded from the accommodation groove, and brought into contact with the other one of the mounting frame and the door frame when the mounting frame is mounted on the door frame.

The display sealing member may be provided with a plurality of contact portions brought into contact with the other one of the mounting frame and the door frame, respectively. The plurality of contact portions may be disposed to be separated from each other in a width direction, and extended in parallel along a length direction to form a plurality of sealing loops.

The laundry treating apparatus may further include a display cover formed of a light transmitting material, and disposed to cover the display; and a filler configured to fill a gap between the mounting frame and the display cover.

The door frame may include an outer frame formed with a sealant filling groove to fill sealant for adhesion to the door cover on a front surface; and an inner frame coupled to a rear side of the outer frame. The outer frame may be disposed to cover the mounting frame.

The mounting frame may be configured to be mounted on a front surface of the outer frame and covered by the door cover, and sealant filled into the sealant filling groove may be configured to surround the display sealing member.

A circumferential portion of the inner frame may form a mounting guide protruded from a front surface of the outer frame to surround an outer circumference of the door cover.

The mounting frame may be mounted on a rear surface of the outer frame, and a frame cover may be mounted at a rear surface side of the outer frame to cover the mounting frame.

A touch sensor may be adhered to a rear surface of the door cover to sense a touch input to the light transmitting region. A communication portion configured to communicate with an inner space formed by the outer frame and the inner frame may be formed on the inner frame, and a frame cover configured to open and close the communication portion may be detachably coupled to the inner frame.

The laundry treating apparatus may further include a touch sensor adhered to a rear surface of the door cover to sense a touch input to the light transmitting region.

A display hole corresponding to the display and a communication hole passing through a flexible printed circuit board (FPCB) of the touch sensor may be formed on the door frame. The display sealing member may be formed to surround the display hole and the communication hole.

The display may be mounted at one side of the mounting frame, and a printed circuit board (PCB) electrically connected to the display and the flexible printed circuit board may be mounted at the other side thereof.

A wireless communication module capable of performing wireless communication with an external electronic device may be further mounted at the other side of the mounting frame.

The laundry treating apparatus may further include a PCB cover mounted on the mounting frame and disposed to cover the printed circuit board; and a PCB sealing member disposed between the mounting frame and the PCB cover and formed to surround the printed circuit board.

The PCB sealing member may be formed to surround the FPCB hole.

A mounting groove configured to accommodate part of the PCB sealing member, and formed to surround the printed circuit board may be formed on either one of the mounting frame and the PCB cover.

Another part of the PCB sealing member may be formed to be protruded from the mounting groove, and brought into contact with the other one of the mounting frame and the PCB cover when the PCB cover is mounted on the mounting frame.

The PCB sealing member may be provided with a plurality of contact portions brought into contact with the other one of the mounting frame and the PCB cover, respectively. The plurality of contact portions may be disposed to be separated from each other in a width direction, and extended in parallel along a length direction to form a plurality of sealing loops.

The display sealing member may be provided with a plurality of contact portions brought into contact with the mounting frame, respectively. The plurality of contact portions may be disposed to be separated from each other in a width direction, and extended in parallel along a length direction to form a plurality of sealing loops.

The PCB sealing member may be provided with a plurality of contact portions brought into contact with the PCB cover, respectively. The plurality of contact portions may be disposed to be separated from each other in a width direction, and extended in parallel along a length direction to form a plurality of sealing loops.

According to the present disclosure, a non-light-transmitting region and a first and a second light transmitting region divided from each other within the non-light-transmitting region are formed on a door cover, and a window portion and a display portion (or touch screen) may be formed in the first and the second light transmitting region, respectively, to implement a simple door appearance. In particular, when the first and the second light transmitting region are formed in a circular shape to correspond to a circular shaped door, it may be possible to give an integrated aesthetic sense to the user.

Moreover, the second light transmitting region is formed in a circular shape disposed to overlap within a rectangular display, visual information may be displayed only on a portion corresponding to the circular shaped second light transmitting region, thereby providing a circular shaped display portion to the user. Here, the controller may control the display of visual information to a portion that does not correspond to the second light transmitting region within the display, thereby reducing power.

According to the present disclosure, a mounting guide of the door frame may be configured with a first protrusion portion in a round shape and a second protrusion portion in a linear shape corresponding to a first and a second edge portion of the door, respectively, and thus the door cover may be a reference point capable of adjusting an installation position between the second edge portion and the second protrusion portion when the door cover is assembled to the door frame. In other words, when the second edge portion is disposed to correspond to the second protrusion portion, the door cover may be located at a normal position on the door frame, and thus the first and the second light transmitting region of the door cover may be disposed to correspond to the first and the second opening portion of the door frame.

According to the present disclosure, even though sealant filled into the sealant coating portion is leaked out during the process of coupling the door cover to the outer frame, it is configured to collect sealant leaked into the sealant collecting portion provided at an inner and an outer side of the sealant coating portion, respectively. As a result, it may be possible to prevent the deterioration of appearance quality due to the leakage of sealant.

Furthermore, according to the foregoing structure, the sealant coating portion may be disposed closer to an edge portion of the outer frame to the maximum extent. Accordingly, it may be possible to minimize a non-joint portion on an edge portion of the corresponding door cover, thereby enhancing the joint strength, and effectively preventing foreign substances from being infiltrated through a gap between the door cover and the outer frame.

A display sealing member may be disposed between the door frame and the mounting frame, thus having a structure capable of preventing moisture from being infiltrated into a flexible printed circuit board between the display and the touch screen provided therein. Here, a filler may be filled into a gap between the mounting frame and the door cover, and in this case, it may be possible to prevent moisture from being infiltrated into the display once more.

Furthermore, a PCB sealing member may be disposed between the mounting frame and the PCB cover, thus having a structure capable of preventing moisture from being infiltrated into the printed circuit board and wireless communication module.

The display sealing member and PCB sealing member may include a plurality of contact portions disposed to be separated from each other in a width direction, and extended in parallel along a length direction to form a plurality of sealing loops. In this case, a sealing loop formed by any one contact portion may be disposed within a sealing loop formed by another contact portion, thereby enhancing the reliability of the sealing structure.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:
FIG. 1 is a perspective view illustrating a laundry treating apparatus according to an embodiment of the present disclosure;
FIG. 2A is a conceptual view illustrating a configuration in which a door illustrated in FIG. 1 is primarily rotated to open a laundry inlet;
FIG. 2B is a conceptual view illustrating a configuration in which a door is secondarily rotated in the configuration illustrated in FIG. 2A;
FIG. 3 is an exploded perspective view of a door illustrated in FIG. 1;
FIG. 4 is a front view of a door illustrated in FIG. 1;
FIG. 5 is a rear view of a door cover illustrated in FIG. 3;
FIG. 6 is a cross-sectional view illustrating a first embodiment of a door cover taken along line A-A' illustrated in FIG. 5;
FIG. 7 is an enlarged view of a portion "B" illustrated in FIG. 5;
FIG. 8 is a cross-sectional view illustrating a second embodiment of a door cover taken along line A-A' illustrated in FIG. 5;
FIG. 9 is a cross-sectional view illustrating a third embodiment of a door cover taken along line A-A' illustrated in FIG. 5;
FIG. 10 is a cross-sectional view taken along line C-C' illustrated in FIG. 4;
FIG. 11 is a conceptual view in which a door cover and a door frame are shown in a separate manner on a portion "D" illustrated in FIG. 4;
FIG. 12 is a front view illustrating a first embodiment of a door frame illustrated in FIG. 3;
FIG. 13 is an enlarged view of a portion "E" illustrated in FIG. 12;
FIG. 14 is a front view illustrating a second embodiment of a door frame illustrated in FIG. 3;
FIGS. 15 and 16 are exploded perspective views in which a display module illustrated in FIG. 3 is seen from different directions;
FIG. 17 is a front view of a mounting frame illustrated in FIG. 15;
FIG. 18 is a rear view of a mounting frame illustrated in FIG. 15;
FIG. 19 is a rear view illustrating a configuration in which a PCB cover is coupled to a mounting frame illustrated in FIG. 15;
FIG. 20 is a cross-sectional view taken along line F-F' illustrated in FIG. 4;
FIG. 21 is a conceptual view illustrating a configuration in which a display module illustrated in FIG. 3 is mounted within a door frame;
FIG. 22 is an exploded perspective view of a door according to a modified example of the present disclosure;
FIG. 23 is a cross-sectional view of a door illustrated in FIG. 22; and
FIGS. 24 through 26 are cross-sectional views illustrating other modified examples of the present disclosure.

### DETAILED DESCRIPTION OF THE INVENTION

Hereinafter, a laundry treating apparatus associated with the present disclosure will be described in more detail with reference to the accompanying drawings.

Even though in different embodiments, and the same or similar elements as or to those of the foregoing embodiments are designated with the same or similar numeral references and their redundant description will be omitted.

In describing the embodiments disclosed herein, moreover, the detailed description will be omitted when a specific description for publicly known technologies to which the invention pertains is judged to obscure the gist of the present invention

Also, it should be noted that the accompanying drawings are merely illustrated to easily explain the concept of the invention, and therefore, they should not be construed to limit the concept of the invention by the accompanying drawings.

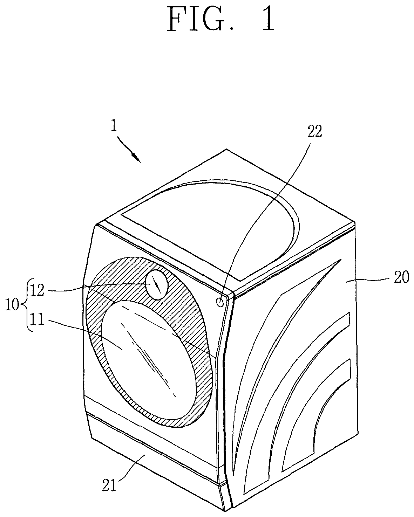

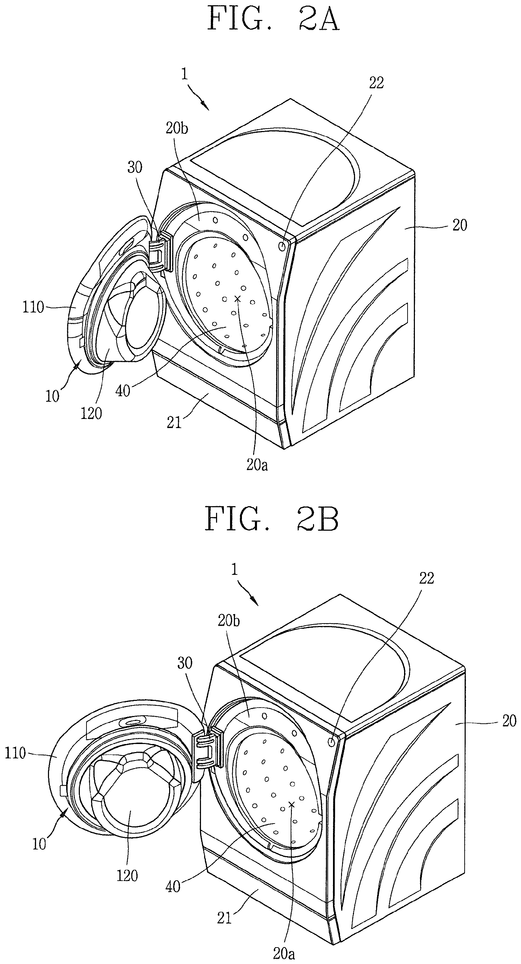

FIG. 1 is a perspective view illustrating a laundry treating apparatus 1 according to an embodiment of the present disclosure, and FIGS. 2A and 2B are conceptual views illustrating a configuration in which a door 10 illustrated in FIG. 1 is primarily and secondarily rotated to open a laundry inlet 20a, respectively.

Referring to the present drawings, a laundry treating apparatus 1 includes a body 20 and a door 10.

The body 20 includes a laundry inlet 20a forming an appearance of the laundry treating apparatus 1 to which laundry is input. According to the present disclosure, it is illustrated that the laundry inlet 20a is formed on a front side portion of the body 20 having a hexahedral shape.

A laundry accommodation portion into which laundry is accommodated through the laundry inlet 20a is provided within the body 20.

For an example, when the laundry treating apparatus 1 according to the present disclosure is configured as an apparatus for drying laundry, the laundry accommodation portion may be configured with a drum 40 rotatably provided within the body 20.

For another example, when the laundry treating apparatus 1 according to the present disclosure is configured with an apparatus capable of performing the washing and drying of laundry at the same time, the laundry inlet may be configured with a tub (not shown) provided within the body 20 to store wash water and a drum 40 rotatably provided within the tub to accommodate laundry.

A drive unit (not shown) configured to rotate the drum 40 is provided in the body 20. The drive unit may include a motor configured to generate a driving force and a belt configured to rotate the drum 40 using the driving force.

A detergent supply unit (not shown) may be provided in the body 20 to be pulled out or in a withdrawable manner. A cover 21 covering the detergent supply unit may be rotatably configured in a vertical direction.

A power button 22 may be provided in the body 20 to turn or off the power of the laundry treating apparatus 1. When a display 12 which will be described later is configured with a touch screen, it may be configured to turn on or off the power of the laundry treating apparatus 1 through a touch input to the touch screen 12. In this case, the power button 22 may not be provided therein to implement a simpler appearance.

The door 10 is configured to be relatively rotatable with respect to the body 20 to open or close the laundry inlet 20a. As illustrated in the drawing, the door 10 may be provided to rotate with respect to body 20 by a hinge unit 30.

The body 20 may include a door accommodation portion 20b recessed in an inward direction on an outer surface thereof to have the laundry inlet 20a therewithin. In a state that that the door 10 is closed, the door 10 may be accommodated into the door accommodation portion 20b, and an edge portion of the outer surface of the door cover may be disposed to form the same plane as that of an outer surface of the body 20 adjacent thereto.

Due to a structure in which the door 10 is accommodated into the door accommodation portion 20b, in order that the door 10 is not engaged with the body 20 during the opening of door 10 as described above, the hinge unit 30 may have a double hinge structure having two different rotating shafts. In this case, as illustrated in FIGS. 2A and 2B, it may be configured such a manner that the door 10 is separated from the door accommodation portion 20b by primary rotation to any one rotating shaft, and then the body 20 is rotated by secondary rotation due to another rotating shaft.

In a structure in which the hinge unit 30 is mounted at one side of the door 10, a locking device for fixing or releasing the door 10 to or from the body 20 is provided at the other side of the door 10. The locking device is configured with a press type,, and configured to lock the door 10 when the other side of the door 10 is pressed once and release the door 10 when pressed once again.

The door 10 may include a window portion 11 and a display portion 12.

In a state that the door 10 is closed, the window portion 11 is disposed to correspond to the laundry inlet 20a, and configured to view the laundry accommodation portion. Accordingly, the user may check the status of laundry accommodated into the laundry accommodation portion through the window portion 11.

The display portion 12 displays (outputs) information processed by the laundry treating apparatus 1. For example, the display portion 12 may display the execution screen information of cycles (washing, dehydration, drying cycles, etc.) driven by the laundry treating apparatus 1 or user interface (Ul), graphic user interface (GUI) information corresponding to the execution screen information.

Hereinafter, the detailed structure of the door 10 will be described.

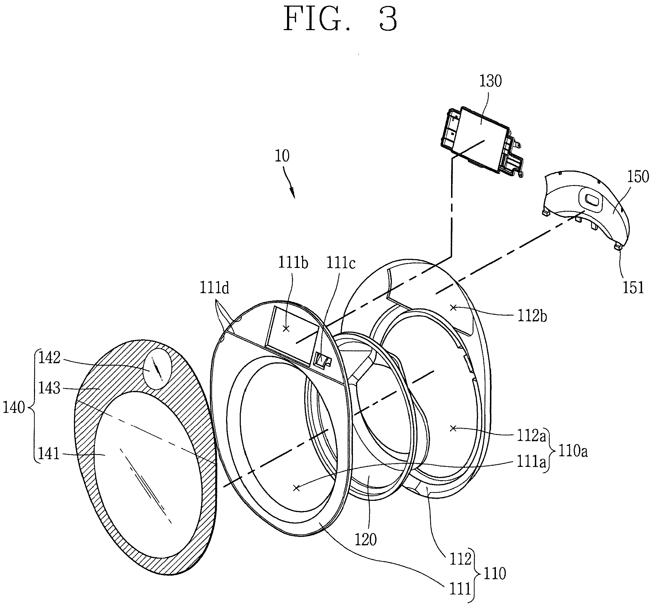

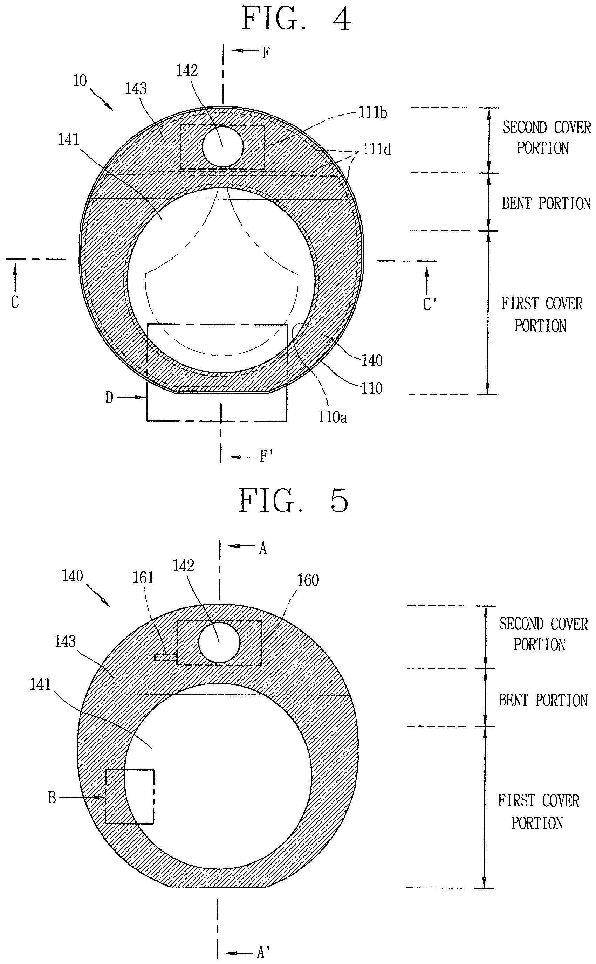

FIG. 3 is an exploded perspective view of the door 10 illustrated in FIG. 1, and FIG. 4 is a front view of the door illustrated in FIG. 1.

Referring to FIGS. 3 and 4, the door 10 includes a door frame 110, a door window 120, a display module 130 and a door cover 140. As described above, the hinge unit 30 for coupling to the body 20 is mounted on the door 10, but the hinge unit 30 will be omitted on the present drawing.

On the present embodiment, it is shown that the door 10 is formed in a circular shape (including a right circular shape, an elliptical shape, or a round shape at least part of which is formed in a round manner). However, the present disclosure may not be necessarily limited to this. The door 10 may be formed in a polygonal shape (rectangular shape, hexagonal shape, etc.).

The door frame 110 is rotatably coupled to the body 20, and to this end, the hinge unit 30 is coupled to the door frame 110 and body 20, respectively.

As illustrated in the drawing, the door frame 110 may include an outer frame 111 and an inner frame 112. The outer frame 111 and inner frame 112 may be formed of a synthetic resin material (for example, ABS material, PC material, etc.).

For reference, the reason of being referred to as the outer frame 111 and inner frame 112, respectively, is because the outer frame 111 faces an outside of the body 20, and the inner frame 112 faces an inside of the body 20 when viewing the door frame 110 itself viewed in a state that the door 10 is closed. Without such distinction, the outer frame 111 and inner frame 112 may be also referred to as a first and a second frame, respectively.

The door frame 110 includes a first opening portion 110a facing the laundry inlet 20a in a state that the door 10 is closed and a second opening portion 111b corresponding to the display module 130 mounted therewithin. The first opening portion 110a may be also referred to as a door window hole in the aspect that the door window 120 is installed at the first opening portion 110a, and the second opening portion 111b may be also referred to as a display hole in the aspect that the display module 130 is mounted at the second opening portion 111b. The second opening portion 111b may be located on the first opening portion 110a.

The first opening portion 110a may include a front side opening portion 111a formed on the outer frame 111 and a rear side opening portion 112a formed on the inner frame 112. The second opening portion 111b is formed on the outer frame 111. A communication portion 112b may be formed on the rear side opening portion 112a of the inner frame 112, and the display module 130 may be mounted within the door frame 110 through the communication portion 112b.

The door frame 110 is installed on the door window 120 to correspond to the first opening portion 110a. The door window 120 is formed of a light transmitting material (glass, synthetic resin material, etc.), and disposed to correspond to the laundry inlet 20a in a state that the door 10 is closed.

The display module 130 is installed within the door frame 110. The display module 130 is disposed to correspond to the second opening portion 111b, and a display 132 provided in the display module 130 is configured to display visual information associated with information processed in the laundry treating apparatus 1.

Moreover, a FPCB hole 111c through which a flexible printed circuit board (FPCB) of the touch sensor 160 can pass may be provided on the door frame 110. According to the present drawing, it is shown that the FPCB hole 111c is provided at one side of the second opening portion 111b.

The door cover 140 forming an appearance of the door 10 is coupled to the door frame 110. The door cover 140 may be formed of a glass material or synthetic resin material having light transmitting characteristics.

The door cover 140 includes a non-light-transmitting region 143, and a first light transmitting region 141 corresponding to the first opening portion 110a and a second light transmitting region 142 corresponding to the second opening portion 111b. Here, the light transmitting region denotes a region configured to pass at least part of light through which an opposite side thereof or inside thereof is seen.

The first and the second light transmitting region 141, 142 are partitioned from each other by the non-light-transmitting region 143. According to the present embodiment, it is shown that the door frame 110 and door cover 140 are formed in a circular shape to connected to the door 10 having a circular shape, and the first and the second light transmitting region 141, 142 are formed in a circular shape to give an integrated aesthetic sense to the user.

The door cover 140 may be formed such that at least part thereof has a bent shape. For example, a first cover portion and a second cover portion at both sides of the bending portion may be formed in an inclined manner with respect to each other by the bent bending portion. Here, the first cover portion and second cover portion are formed in a flat shape. The door frame 110 may be also formed in such a manner that at least part thereof is bent to correspond to the door cover 140.

According to the present embodiment, it is shown that the first light transmitting region 141 is formed across the first cover portion and bending portion, and the second light transmitting region 142 is formed on the second cover portion.

On the other hand, the second light transmitting region 142 is formed in a smaller size than that of the second opening portion 111b, and disposed to overlap within the second opening portion 111b when the door cover 140 is coupled to the door frame 110.

As illustrated in the drawing, the second opening portion 111b is formed in a rectangular shape corresponding to the display module 130 having a rectangular shape, and the second light transmitting region 142 is formed in a circular shape disposed to overlap within the second opening portion 111b. In other words, the second light transmitting region 142 is disposed to overlap with part of the display module 130, and the non-light-transmitting region 143 is disposed to cover and hide another part of the display module 130. Due to the foregoing configuration, visual information may be displayed only on a portion corresponding to the second light transmitting region 142 having a circular shape to provide the display portion 12 having a circular shape to the user.

The cost of a circular display is higher than that of a rectangular display 132 that is typically and widely used, and its assembly failure may frequently occur due to difficulties in getting an accurate installation position due to the shape thereof. However, according to the foregoing structure, it may be possible to provide a display portion 12 that is seen as a circular shape for the user while using the rectangular display 132 with a lower cost that can be assembled at an accurate position.

The second light transmitting region 142 is surrounded by the non-light-transmitting region 143, and thus visual information displayed on a portion that does not correspond to the second light transmitting region 142 within the display 132 is not seen by the user. Taking this into account, visual information may not be displayed on a portion that does not correspond to the second light transmitting region 142 within the display 132.

For an example, an edge image surrounding the visual information may be displayed on a portion that does not correspond to the second light transmitting region 142 in a state that visual information associated with information processed in the laundry treating apparatus 1 is displayed on a portion corresponding to the second light transmitting region 142. The edge image as a portion that does not correspond to the second light transmitting region 142 may be filled with a specific series of colors (for example, black).

For another example, a portion that does not correspond to the second light transmitting region 142 may be configured to be off in a state that visual information associated with information processed in the laundry treating apparatus 1 is displayed on a portion corresponding to the second light transmitting region 142. In other words, an edge image as well as visual information is not displayed on a portion that does not correspond to the second light transmitting region 142 within the display module 130. According to the present example, only part of the display 132 may be operated to allow the efficient operation of the display 132 compared to the foregoing example in which the whole display 132 is operated, thereby obtaining an energy saving effect.

FIG. 5 is a rear view of the door cover 140 illustrated in FIG. 3.

The display portion 12 formed on the door cover 140 may form an interlayer or integrated structure with the touch sensor 160 to implement the touch screen 12. The touch screen 12 may provide an output interface between the laundry treating apparatus 1 and the user while at the same time functioning as a user input unit providing an input interface between the laundry treating apparatus 1 and the user. For example, the selection and change of an operation mode for performing washing, dehydration, drying cycles, and the like may be implemented by the user's touch input (or touch).

The touch sensor 160 is provided at the door 10 to sense a touch input to the door cover 140.

The touch sensor 160 senses a touch input applied to the display portion (or touch screen) 12 using at least one of various touch methods, such as a resistive method, a capacitive method, an infrared method, an ultrasonic method, a magnetic method, and the like.

For an example, the touch sensor 160 may be configured to convert a change such as a pressure applied to a specific portion of the touch screen 12 or a capacitance generated at a specific portion or the like into an electrical input signal. The touch sensor 160 may be configured to detect a position, an area, a pressure during touch or the like at which a touch object applying a touch to the display portion 12 is touched on the touch sensor 160. Here, the touch object as an object applying a touch to the touch sensor 160 may include a finger, a touch pen or stylus pen, a pointer, and the like, for example.

When there is a touch input to the touch sensor 160 as described above, signal(s) corresponding thereto area sent to the controller. The controller may process the signal(s) and then transmit the corresponding data to the controller (not shown). As a result, the controller may know which region of the display portion 12 has been touched or the like. Here, the controller may be an additional configuration to the controller or the controller itself.

On the other hand, the controller may perform a different control operation according to the type of a touch object touching the display portion 12 or perform the same control operation. Whether to perform a different control operation or perform the same control operation according to the type of the touch object may be determined by the operation status of the laundry treating apparatus 1 or an application program being executed.

The touch sensor 160 may sense various types of touches such as a short or tap touch, a long touch, a multi touch, a drag touch, a flick touch, a pinch-in touch, a pinch-out touch, a swype touch, a hovering touch, and the like.

The touch sensor 160 is configured to sense a touch input to a sensing region including the second light transmitting region 142.

According to the present embodiment, it is illustrated that the touch sensor 160 is adhered to a rear surface of the door cover 140 to cover the second light transmitting region 142 and part of the non-light-transmitting region 143 surrounding the second light transmitting region 142. According to the foregoing configuration, the sensing region of the touch sensor 160 may include part of the non-light-transmitting region 143 surrounding the second light transmitting region 142 as well as the second light transmitting region 142. Accordingly, it may be possible to provide various Uls or GUIs using part of the non-light-transmitting region 143 surrounding the second light transmitting region 142.

According to the foregoing structure, the touch sensor 160 may be formed in a touch film type having a touch pattern, and disposed between the door cover 140 and the display module 130. The touch film may be configured with a transparent conductive film, and previously known films such as an indium tin oxide (ITO) film, a carbon nano tube (CNT) film, or the like may be used for the touch film.

The touch film may be configured with a single or double layer. For an example, when the touch film is a glass-film-film (GFF) configured with a double layer, the touch film may be adhered to a rear surface of the door cover 140 or adhered to the display module 130. For another example, when the touch film is a glass-film (G1F) configured with a single layer, the touch film may be adhered to a rear surface of the door cover 140 and integrally formed with the door cover 140.

The touch sensor 160 may be formed in such a manner that a metal wire is directly patterned on a rear surface of the door cover 140 without an additional touch film [Glass only (G2)].

Alternatively, the touch sensor 160 may be integrally formed with the display 132 provided in the display module 130. For example, the touch sensor 160 may be disposed on a substrate of the display 132 (on-cell) or provided within the display 132 (in-cell).

On the other hand, the operation of the display portion 12 of the laundry treating apparatus 1 is controlled by the controller. In other words, the controller 180 controls the on/off of the display module 130, and the display of visual information or image, and controls the on/off of the touch sensor 160.

Here, the controller may be configured to control whether to activate touch sensing to a region that does not correspond to the second light transmitting region 142 within a sensing region of the touch sensor 160. For example, the controller may be configured to distinguish a state in which touch sensing for a region that does not correspond to the second light transmitting region 142 within the sensing region of the touch sensor 160 is required from a state in which the touch sensing is not required to deactivate the touch sensing for the non-corresponding region in the state that the touch sensing is not required. According to the control, it may be possible to reduce an error during the user's touch input and obtain an energy saving effect.

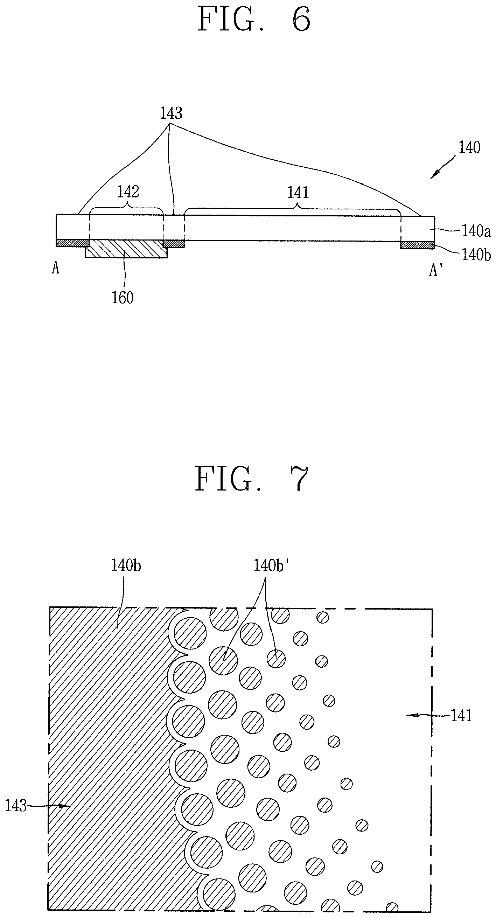

FIG. 6 is a cross-sectional view illustrating a first embodiment of the door cover 140 taken along line A-A' illustrated in FIG. 5.

Referring to FIG. 6, the door cover 140 may include a cover body 140a and a shield layer 140b.

The cover body 140a is formed of a light transmitting material. The cover body 140a may be formed of a light transmitting glass material or synthetic resin material. The cover body 140a may be formed in a shape in which at least part thereof is bent.

The shield layer 140b is disposed to cover one surface of the cover body 140a to form the non-light-transmitting region 143. The shield layer 140b may be formed on a front surface or rear surface of the cover body 140a.

According to the present embodiment, it is illustrated that ink is printed on a rear surface of the cover body 140a to form the shield layer 140b. The ink may include a pigment having a specific series of colors (for example, black).

As illustrated in the drawing, the shield layer 140b is not disposed in the first and the second light transmitting region 141, 142. In other words, the first and the second light transmitting region 141, 142 is a transparent portion remaining as a light transmitting cover body 140a without being covered by the shield layer 140b.

The touch sensor 160 may be adhered to a rear surface of the cover body 140a corresponding to the second light transmitting region 142, and here, the touch sensor 160 may be configured to cover part of the shield layer 140b for restricting the second light transmitting region 142.

FIG. 7 is an enlarged view of a portion "B" illustrated in FIG. 5.

Referring to FIG. 7, the transparency of the shield layer 140b for restricting the first light transmitting region 141 within the door cover 140 may be formed to gradually vary as being located closer to the first light transmitting region 141.

For example, the non-light-transmitting region 143 adjacent to the first light transmitting region 141 may be configured to be gradually transparent as being located closer to the first light transmitting region 141. To this end, the shield layer 140b may include a plurality of shield dots 140b' formed adjacent to the first light transmitting region 141, and the density of the plurality of shield dots 140b' may be formed to decrease as being located closer to the first light transmitting region 141.

By blurring a boundary to the first light transmitting region 141 through such a halftone technique, the non-light-transmitting region 143 may visually and naturally change to the first light transmitting region 141.

On the contrary, the second light transmitting region 142 and the non-light-transmitting region 143 configured to surround the same may be clearly divided in the form of a boundary line by the non-light-transmitting region 143.

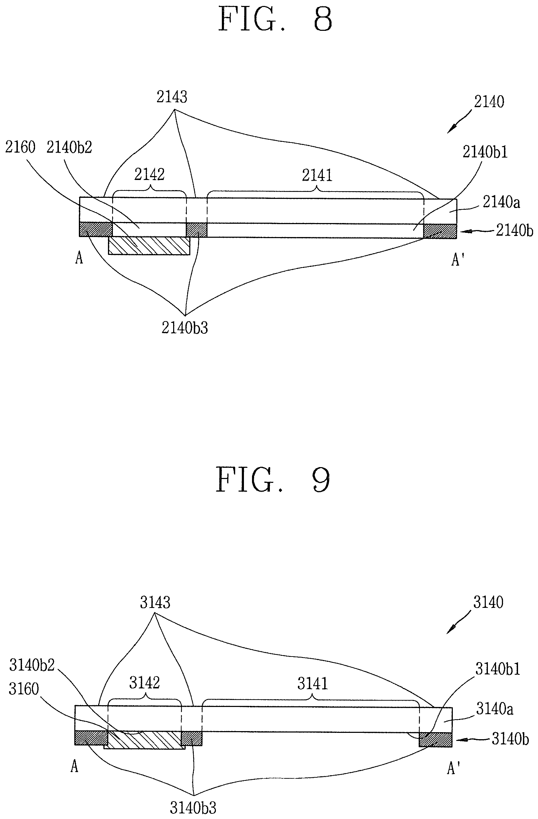

FIG. 8 is a cross-sectional view illustrating a second embodiment of the door cover 140 taken along line A-A' illustrated in FIG. 5.

Contrary to the foregoing first embodiment in which the shield layer 140b is printed on a rear surface of the cover body 140a, according to the present embodiment, a film 2140b for forming a non-light-transmitting region 2143 may be adhered to a rear surface of the cover body 2140a.

As illustrated in the drawing, the film 2140b may include a non-light-transmitting portion 2140b3 corresponding to the non-light-transmitting region 2143, a first light transmitting portion 2140b1 corresponding to a first light transmitting region 2141 and a second light transmitting portion 2140b2 corresponding to a second light transmitting region 2142. The non-light-transmitting portion 2140b3 is formed to surround the first and the second light transmitting portion 2140b1, 2140b2, and the first and the second light transmitting portion 2140b1, 2140b2 are partitioned from each other by the non-light-transmitting portion 2140b3.

Here, a portion corresponding to the non-light-transmitting portion 2140b3 functions as a shield layer for allowing the door cover 2140 to be non-transparent to form the non-light-transmitting region 2143. A portion corresponding to the first and the second light transmitting portion 2140b1, 2140b2 forms the first and the second light transmitting region 2141, 2142, respectively, along with the light transmitting cover body 2140a.

In other words, contrary to the foregoing first embodiment, the first and the second light transmitting region 2141, 2142 are formed by allowing the first and the second light transmitting portion 2140b1, 2140b2, respectively, which are a transparent portion of the film 2140b to be disposed on the light transmitting cover body 2140a.

The touch sensor 2160 may be adhered to a rear surface of the film 2140b corresponding to the second light transmitting portion 2140b2, and here, the touch sensor 2160 may be configured to cover part of the non-light-transmitting portion 2140b3 for restricting the second light transmitting portion 2140b2.

FIG. 9 is a cross-sectional view illustrating a third embodiment of the door cover 140 taken along line A-A' illustrated in FIG. 5.

Similarly to the foregoing second embodiment, according to the present embodiment, a film 3140b for forming a shield layer 3140b may be adhered to a rear surface of the cover body 3140a. As illustrated in the drawing, the film 3140b may include a non-light-transmitting portion 3140b3 corresponding to the non-light-transmitting region 3143, a first hole 3140b1 corresponding to a first light transmitting region 3141 and a second hole 3140b2 corresponding to a second light transmitting region 3142. The non-light-transmitting portion 3140b3 is formed to surround the first and the hole 3140b1, 3140b2, and the first and the second hole 3140b1, 3140b2 are partitioned from each other by the non-light-transmitting portion 3140b3.

Here, a portion corresponding to the non-light-transmitting portion 3140b3 functions as a shield layer for allowing the door cover 3140 to be non-transparent to form the non-light-transmitting region 3143. The first and the second hole 3140b1, 3140b2 are formed on a portion corresponding to the first and the second light transmitting region 3141, 3142, thereby allowing the film 3140b not to be disposed thereon, and the light transmitting cover body 3140a to remain.

The touch sensor 3160 may be adhered to a rear surface of the film 3140b corresponding to the second light transmitting region 3142, and here, the touch sensor 3160 may be configured to cover part of the non-light-transmitting portion 3140b3 for restricting the second light hole 3140b2.

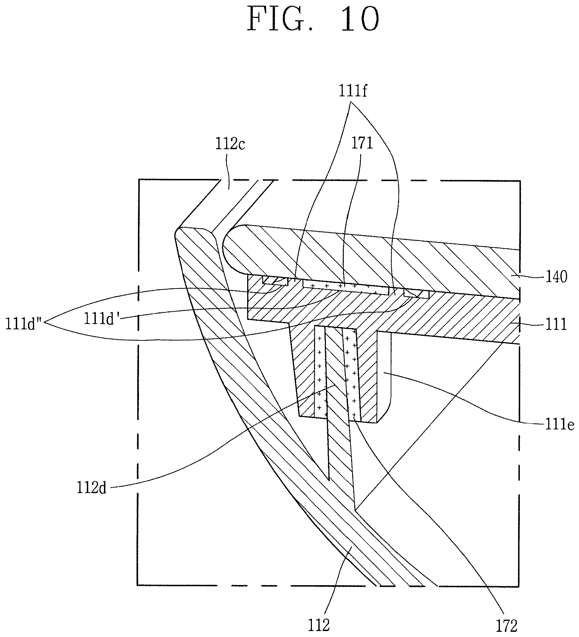

FIG. 10 is a cross-sectional view taken along line C-C' illustrated in FIG. 4.

Referring to FIG. 10, the door cover 140 is coupled to the door frame 110. For the coupling, a liquid phase sealant 171 may be used. A coupling structure between the door cover 140 and the door frame 110 will be described in detail later.

As described above, the door frame 110 may include an outer frame 111 and an inner frame 112.

The outer frame 111 is configured such that the door cover 140 is adhered to a front surface thereof. The inner frame 112 is coupled to a rear side of the outer frame 111. A coupling between the outer frame 111 and the inner frame 112 may be carried out by a screw coupling, a hook coupling, a bonding coupling, or the like.

According to the present drawing, it is illustrated the outer frame 111 and the inner frame 112a are coupled to each other by a bonding coupling. Specifically, a fastening rib 112d is formed in a protruding manner on the inner frame 112, and a rib accommodation portion 111e for accommodating the fastening rib 112d is formed in a protruding manner on a rear surface of the outer frame 111, and a bonding member 172 is filled into the rib accommodation portion 111e.

On the other hand, during coupling between the outer frame 111 and the inner frame 112, an outer circumferential portion of the inner frame 112 is formed in a protruding manner on a front surface of the outer frame 111 to form a mounting guide 112c. The mounting guide 112c is extended in a loop shape along a circumference of the outer frame 111 to form a space for accommodating the door cover 140 therein.

The mounting guide 112c may be disposed to cover a lateral surface of the door cover 140, and an upper surface of the mounting guide 112c may be formed in a protruding manner at a predetermined height to form the same plane as an upper surface of the adjoining door cover 140. According to the foregoing configuration, a step between the mounting guide 112c and the door cover 140 may decrease to implement a more simpler design.

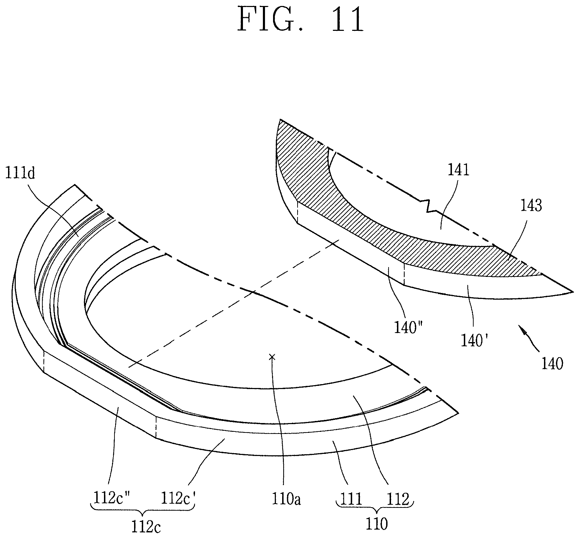

FIG. 11 is a conceptual view in which the door cover 140 and the door frame 110 are shown in a separate manner on a portion "D" illustrated in FIG. 4.

In general, a portion (for example, a vertex portion, a concave portion, etc.) having a unique shape may be a reference point capable of adjusting an installation position during assembly, thereby facilitating the assembly. However, as illustrated in the present embodiment, when the door cover 140 is formed in a circular shape, an apex portion has a round shape, thereby causing a problem in which a portion capable of adjusting an installation position during assembly is unsuitable. In particular, in case of the present disclosure, unless the door cover 140 is coupled to an accurate position on the door frame 110, it may cause a problem in which the first and the second light transmitting region 141, 142 of the door cover 140 do not correspond to the first and the second opening portion 110a, 111b of the door frame 110.

In order to solve the foregoing problem, as illustrated in FIG. 11, the door cover 140 may include a portion that will be a reference point capable of adjusting an installation position while being assembled to the door frame 110.

Specifically, the door cover 140 may include a first edge portion 140' formed in a round manner and a second edge portion 140" for connecting both sides of the first edge portion 140'. As illustrated in the drawing, the door cover 140 may have a circular shape in which part thereof is cut in a linear form. The second edge portion 140" may have any form that is distinguishable in shape from the first edge portion 140' such as a linear form, a rugged form, or the like.

The foregoing mounting guide 112c may include a first protrusion portion 112c' extended in a round manner to correspond to the first edge portion 140' and a second protrusion portion 112c" extended in a linear shape to correspond to the second edge portion 140".

According to the foregoing configuration, the second edge portion 140" and second protrusion portion 112c" may be a reference point capable of adjusting an installation position during assembly between the door cover 140 and the door frame 110. In other words, when the second edge portion 140" is disposed to correspond to the second protrusion portion 112c", the door cover 140 may be located at a normal position on the door frame 110, and thus the first and the second light transmitting region 141, 142 of the door cover 140 may be disposed to correspond to the first and the second opening portion 110a, 111b of the door frame 110.

The second protrusion portion 112c" may be located at any position of the door frame 110, but the second protrusion portion 112c" may be preferably formed at a lower side of the door frame 110 not to allow the user to recognize the door 10 in a circular cut shape.

Hereinafter, a coupling structure between the door cover 140 and the door frame 110 will be described.

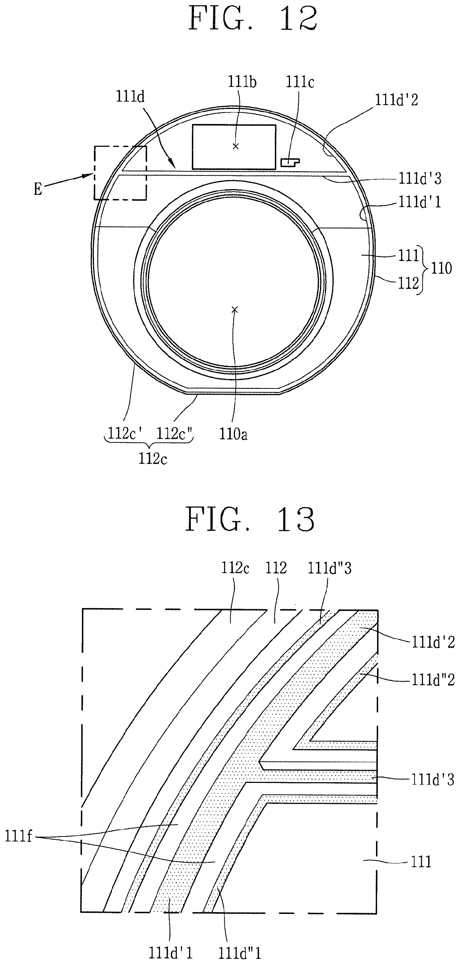

FIG. 12 is a front view illustrating a first embodiment of the door frame 110 illustrated in FIG. 3, and FIG. 13 is an enlarged view of a portion "E" illustrated in FIG. 12.

As described above, the door 10 is coupled to a front surface of the outer frame 111. For the coupling, a sealant 171 is used, and a sealant filling groove 111d into which the sealant 171 is filled is formed on a front surface of the outer frame 111.

The sealant filling groove 111d is formed to surround the first opening portion 110a and second opening portion 111b, respectively. To this end, the sealant filling groove 111d may include a connecting groove portion 111d'3, a first groove portion 111d'1 and a second groove portion 111d'2.

The connecting groove portion 111d'3 is formed to cross between the first and the second opening portion 110a, 111b. The connecting groove portion 111d'3 may be formed in a linear shape or a bent shape on at least one portion thereof (for example, in a U-shape surrounding both sides and a lower side of the second opening portion 111b) as illustrated in the drawing.

The first groove portion 111d'1 is connected to both end portions of the connecting groove portion 111d'3, and formed to surround a circumference of the first opening portion 110a along with the connecting groove portion 111d'3. The first groove portion 111d'1 may be extended along an inner circumference of the outer frame 111.

The second groove portion 111d'2 is connected to both end portions of the connecting groove portion 111d'3, and formed to surround a circumference of the second opening portion 111b along with the connecting groove portion 111d'3. The second groove portion 111d'2 may be extended along an inner circumference of the outer frame 111.

The first groove portion 111d'1 and the second groove portion 111d'2 may be formed to communicate with each other at both end portions of the connecting groove portion 111d'3.

According to the present drawing, it is illustrated that the first and the second groove portion 111d'2 are extended along an inner circumference of the outer frame 111 to form a circular groove, and the connecting groove portion 111d'3 is extended in a linear shape to cross an inside of the circular groove.

On the other hand, referring to FIG. 10 illustrated in the above at the same time, the sealant filling groove 111d may include a sealant coating portion 111d' and a sealant collecting portion 111d".

The sealant coating portion 111d' as a portion for the filling of the sealant 171 may include the foregoing connecting groove portion 111d'3, first groove portion 111d'1 and second groove portion 111d'2.

The sealant collecting portion 111d" for collecting the sealant 171 leaked out of an inner and an outer side of the sealant coating portion 111d', respectively is provided at both sides of the sealant coating portion 111d'. The sealant collecting portion 111d" may be extended in parallel along the sealant coating portion 111d' in a state of being separated from the sealant coating portion 111d' by interposing a predetermined distance therebetween. The sealant collecting portion 111d" may have a smaller width than that of the sealant coating portion 111d'.

A projection 111f may be protruded at a predetermined height between the sealant coating portion 111d' and the sealant collecting portion 111d". The projection 111f may be protruded at a height corresponding to a front surface of the outer frame 111, and in this case, the projection 111f functions as a supporting surface for supporting the door cover 140.

According to the present embodiment, it is illustrated that the sealant collecting portion 111d" includes a first through a third sealant collecting portion 111d"1, 111d"2, 111d"3.

The first sealant collecting portion 111d"1 is provided at an inner side of the sealant coating portion 111d', and formed to surround the first opening portion 110a. The first sealant collecting portion 111d"1 may be extended along the connecting groove portion 111d'3 and the first groove portion 111d'1.

The second sealant collecting portion 111d"2 is provided at an inner side of the sealant coating portion 111d', and formed to surround the second opening portion 111b. The second sealant collecting portion 111d"2 may be extended along the connecting groove portion 111d'3 and the second groove portion 111 d'2.

The third sealant collecting portion 111d"3 is provided at an outer side of the sealant coating portion 111d', and formed to surround the sealant collecting portion 111d'. The third sealant collecting portion 111d"3 may be extended along the first groove portion 111d'1 and the second groove portion 111d'2, and may have a circular shape.

According to the foregoing configuration, even though the sealant 171 filled into the sealant coating portion 111d' is leaked out during the process of coupling the door cover 140 to the outer frame 111, the sealant 171 leaked out to the sealant collecting portion 111d" provided at an inner and an outer side thereof, respectively, may be collected. As a result, it may be possible to prevent the deterioration of appearance quality due to the leakage of the sealant 171.

Furthermore, according to the foregoing structure, the sealant coating portion 111d' may be disposed closer to an edge portion of the outer frame 111 to the maximum extent. Accordingly, it may be possible to minimize a non-joint portion on an edge portion of the corresponding door cover 140, thereby enhancing the joint strength, and effectively preventing foreign substances from being infiltrated through a gap between the door cover 140 and the outer frame 111.

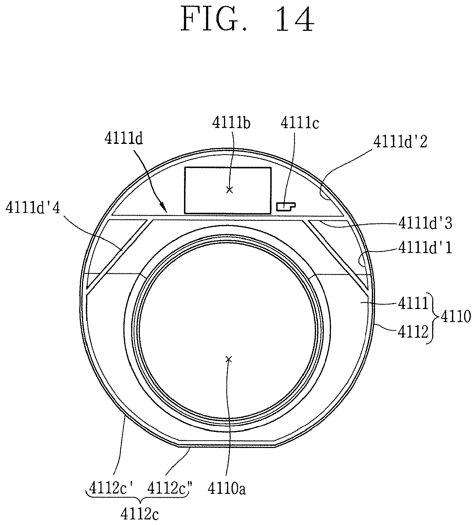

FIG. 14 is a front view illustrating a second embodiment of the door frame 110 illustrated in FIG. 3.

As illustrated in the above embodiment, according to the present embodiment, a sealant filling groove 4111d may include a connecting groove portion 4111d'3, a first groove portion 4111d'1 and a second groove portion 4111 d'2, and may be formed to surround a first and a second opening portion 4110a, 4111b, respectively. The sealant filling groove 4111d may include a sealant coating portion and a sealant collecting portion, and the description thereof will be the same as that of the foregoing first embodiment.

According to the present embodiment, the sealant filling groove 4111 d further includes a bypass groove portion 4111d'4 for connecting between an arbitrary point on the connecting groove portion 4111d'3 and an arbitrary point on the first groove portion 4111d'1. As illustrated in the drawing, the bypass groove portion 4111d'4 is located within a space formed by the connecting groove portion 4111d'3 and the first groove portion 4111d'1.

As a result, part of sealant filled into the connecting groove portion 4111d'3 or first groove portion 4111d'1 is introduced into the branched bypass groove portion 4111d'4, thereby having an effect of increasing a number of couplings between the door cover and the door frame 4110. Accordingly, it may be possible to increase a coupling force between the door cover and the door frame 4110.

The bypass groove portion 4111d'4 may include a sealant coating portion for the filling of sealant, and a sealant collecting portion provided at both sides of the sealant coating portion to collect sealant leaked out of an inner and an outer side of the sealant coating portion, respectively.

On the other hand, the display module 130 may be integrated into the door frame 110, and in the aspect that the door 10 has a configuration of opening and closing the laundry inlet 20a, moisture may be likely to be infiltrated into the display module 130. Accordingly, the sealing of the display module 130 may be a key point in the aspect of securing the reliability of driving the display portion 12.

Hereinafter, a sealing structure of the display module 130 will be described.

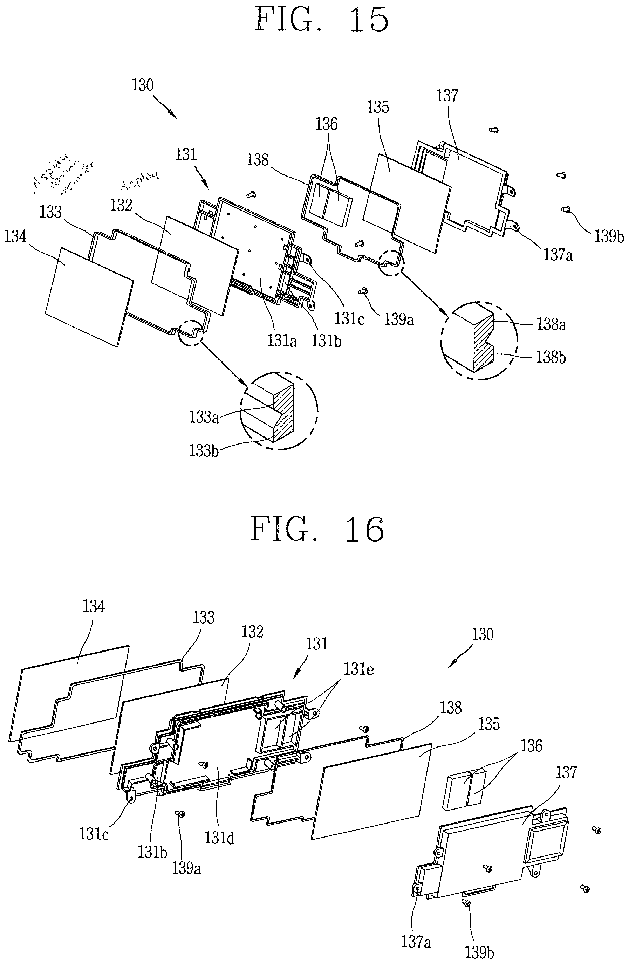

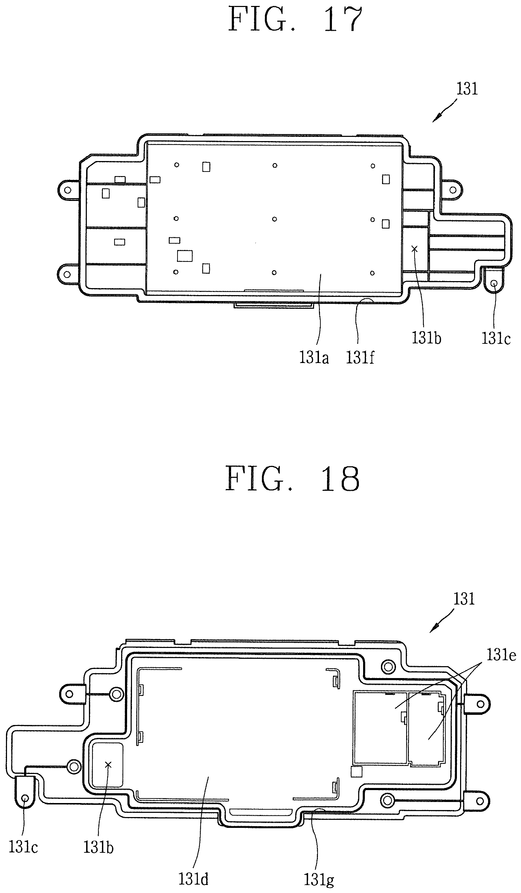

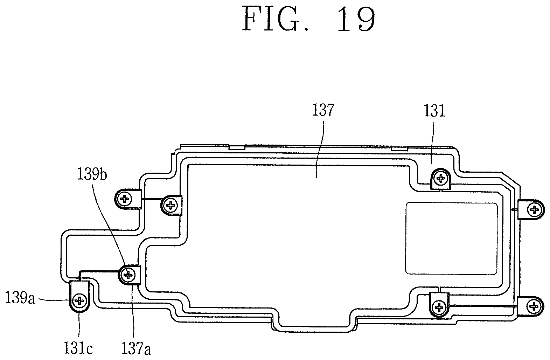

FIGS. 15 and 16 are exploded perspective views in which the display module 130 illustrated in FIG. 3 is seen from different directions. FIG. 17 is a front view of the mounting frame 131 illustrated in FIG. 15, and FIG. 18 is a rear view of the mounting frame 131 illustrated in FIG. 15, and FIG. 19 is a rear view illustrating a configuration in which a PCB cover 137 is coupled to the mounting frame 131 illustrated in FIG. 15.

Referring to FIGS. 15 through 19, the display module 130 may include a mounting frame 131, a display 132 and a display sealing member 133.

The mounting frame 131 may include a display mounting portion 131a in which the display 132 is mounted on one surface thereof. The display mounting portion 131a may include a space recessed on a front surface of the mounting frame 131 toward a rear surface thereof in a shape corresponding to the display 132 or an internal space restricted by a rib formed in a protruding manner to correspond to a circumference of the display 132.

The mounting frame 131 may be formed of a synthetic resin material (for example, ABS material, PC material, etc.).

A communication hole 131b may be formed on the mounting frame 131. The communication hole 131b may be provided at one side of the display mounting portion 131a, and may be a space distinguished from the display mounting portion 131a.

A flexible printed circuit board 161 of the touch sensor 160 may be electrically connected to a printed circuit board 135 through the FPCB hole 111c formed on the door frame 110 and the communication hole 131b formed on the mounting frame 131. A flexible printed circuit board of the display 132 as well as the flexible printed circuit board 161 of the touch sensor 160 may pass through the communication hole 131b.

The display 132 is mounted on the mounting frame 131 to display visual information. The display 132 may include at least one of a liquid crystal display (LCD), a thin film transistor-liquid crystal display (TFT LCD), an organic light-emitting display diode (OLED), a flexible display, a three-dimensional (3D) display, and an e-ink display.

For the display 132, a typically and widely used tetragonal display, more particular, a rectangular display 132 having different horizontal and vertical lengths is used. As described above, the rectangular display 132 has a lower cost compared to a circular display, and has an advantage of facilitating an accurate mounting position while mounting on the mounting frame 131 due to a portion having a unique shape (having a vertex, different horizontal and vertical lengths).

When the display 132 is formed in a rectangular shape, and the second light transmitting region 142 is formed in a circular shape, the length of a shorter portion between the horizontal and vertical lengths should be larger than the diameter of the second light transmitting region 142 (a major axis of the second light transmitting region 142 when the second light transmitting region 142 is formed in an elliptical shape). When the above condition is satisfied, visual information may be displayed on the whole second light transmitting region 142.

Though the rectangular display 132 is used for the display 132, a circular display portion 12 may be provided for the user as a circular second light transmitting region 142 configured to overlap with the display 132 is formed on the door cover 140. Moreover, the controller may control the display of visual information on a portion that does not correspond to the second light transmitting region 142 within the display 132, thereby reducing power.

A display cover 134 formed of a light transmitting material, and disposed to cover the display 132 may be additionally provided on the display 132. The display cover 134 performs a function of covering and protecting the display 132. The display cover 134 may be formed of a synthetic resin material (for example, acryl material, PET material, TPU material, etc.).

The display sealing member 133 is disposed between the door frame 110 and the mounting frame 131, and formed to surround the display 132. When the communication hole 131b is provided in the mounting frame 131, the display sealing member 133 may be preferably formed to surround the display 132 at the same time to enhance the reliability of a watertight structure.

The display sealing member 133 may be fixed to the door frame 110 or fixed to the mounting frame 131. According to the present embodiment, it is illustrated that the display sealing member 133 is fixed to the mounting frame 131 to seal an internal space when the mounting frame 131 is mounted on the door frame 110. To this end, an accommodation groove 131f for the fixing of the display sealing member 133 is formed on the mounting frame 131, and the accommodation groove 131f is formed to surround the display 132. As described above, when the communication hole 131b is provided in the mounting frame 131, the accommodation groove 131f may be preferably formed to surround the display 132 and the communication hole 131b at the same time to enhance the reliability of a watertight structure.

The display sealing member 133 may include a plurality of contact portions 133a, 133b. The plurality of contact portions 133a, 133b is disposed to be separated from each other in a width direction, and extended in parallel along a length direction to form a plurality of sealing loops. Accordingly, a sealing loop formed by either one of the contact portions 133a, 133b may be disposed within a sealing loop formed by the other one of the contact portions 133a, 133b, thereby enhancing the reliability of the sealing structure.

On the other hand, the display module 130 may further include a printed circuit board (PCB) 135, a PCB cover 137, and a PCB sealing member 138.

The printed circuit board 135 is electrically connected to the display 132, and mounted on the mounting frame 131. According to the present embodiment, it is illustrated a structure in which the display 132 is mounted on a front surface of the mounting frame 131, and the printed circuit board 135 is mounted on a rear surface thereof. When the touch sensor 160 is provided therein, the printed circuit board 135 may be electrically connected to the flexible printed circuit board 161 of the touch sensor 160 passing through the communication hole 131b.

The printed circuit board 135 may be a controller for controlling the operation of the display 132 and touch sensor 160 or the controller itself.

A printed circuit board mounting portion 131d may be provided on a rear surface of the mounting frame 131 for the mounting of the printed circuit board 135. The printed circuit board mounting portion 131d may be a space recessed on a rear surface of the mounting frame 131 toward a front surface thereof in a shape corresponding to the printed circuit board 135 or an internal space restricted by a rib formed in a protruding manner to correspond to a circumference of the printed circuit board 135.

A wireless communication module 136 capable of performing wireless communication with an internal external device or external electronic device may be additionally mounted on the mounting frame 131. A wireless communication module mounting portion 131e for the mounting of the wireless communication module 136 may be provided on the mounting frame 131, and the wireless communication module mounting portion 131e may be located at one side of the printed circuit board mounting portion 131d.

The wireless communication module 136 may include at least one of Wi-Fi, Bluetooth, and a communication module using RF. For example, the laundry treating apparatus 1 according to the present disclosure may be configured to perform wireless communication with the user's mobile terminal through a Wi-Fi communication module or Bluetooth communication module. For another example, the laundry treating apparatus 1 according to the present disclosure may be configured to perform wireless communication with another home appliance (for example, another laundry treating apparatus 1) through the RF communication module.

The PCB cover 137 is mounted on the mounting frame 131, and disposed to cover the printed circuit board 135. The PCB cover 137 is fastened to the mounting frame 131 by a screw coupling, a hook coupling, a bonding coupling, or the like. For example, as illustrated in the drawing, a mounting portion 137a formed with a mounting hole is provided on the mounting frame 131, and a mounting member 139b may be screw-coupled to the mounting frame 131 through the mounting hole.

The door 10 has a configuration configured to open and close the laundry inlet 20a, and due to a structure of the present disclosure in which the display portion 12 is provided in the door 10, there is a possibility to introduce moisture generated from the laundry inlet 20a into the printed circuit board 135. For reference, there is no possibility of generating such a problem in a laundry treating apparatus in the related art in which the display portion is provided at an upper portion of the body.

Considering this, a PCB sealing member 138 is disposed between the mounting frame 131 and the PCB cover 137, and configured to seal a gap between the mounting frame 131 and the PCB cover 137. The PCB sealing member 138 is formed to surround the printed circuit board 135, and configured to prevent moisture from being infiltrated into the printed circuit board 135.

When the wireless communication module 136 is additionally provided therein, the PCB sealing member 138 may be preferably formed to surround the printed circuit board 135 and wireless communication module 136 at the same time. Furthermore, when the communication hole 131b is provided on the mounting frame 131, the PCB sealing member 138 is preferably formed to surround the communication hole 131b at the same time to enhance the reliability of a watertight structure.

The PCB sealing member 138 may be fixed to the mounting frame 131 or fixed to the PCB cover 137. According to the present embodiment, it is illustrated that the PCB sealing member 138 is fixed to the mounting frame 131, and configured to seal an internal space when the mounting frame 131 is coupled to the PCB cover 137.

To this end, a mounting groove 131g for fixing the PCB sealing member 138 is formed on the mounting frame 131, and the mounting groove 131g is formed to surround the printed circuit board 135. As described above, the mounting groove 131g may be formed to surround the wireless communication module 136, the communication hole 131b, and the like, at the same time to enhance the reliability of a watertight structure.

If it has a structure in which the PCB sealing member 138 is fixed to the PCB cover 137, a mounting groove for fixing the PCB sealing member 138 may be formed on the PCB cover 137.

The PCB sealing member 138 may include a plurality of contact portions 138a, 138b. The plurality of contact portions 138a, 138b is disposed to be separated from each other in a width direction, and extended in parallel along a length direction to form a plurality of sealing loops. Accordingly, a sealing loop formed by either one of the contact portions 138a, 138b may be disposed within a sealing loop formed by the other one of the contact portions 138a, 138b, thereby enhancing the reliability of the sealing structure.

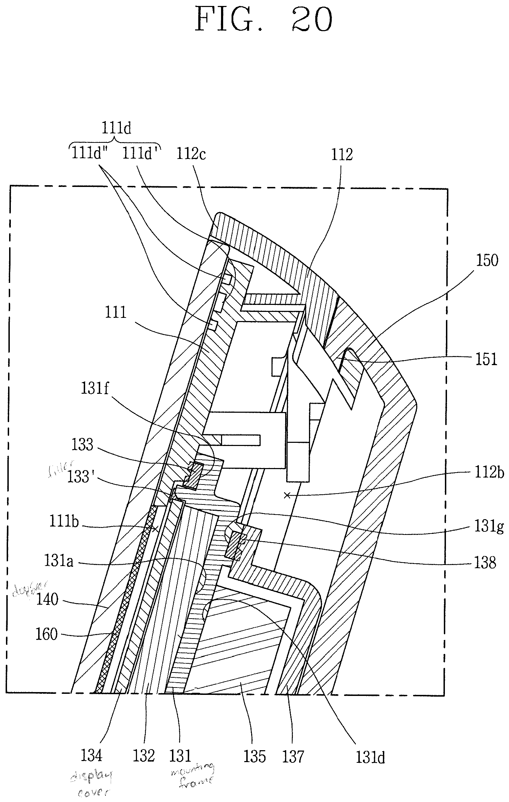

FIG. 20 is a cross-sectional view taken along line F-F' illustrated in FIG. 4.

Referring to FIG. 20, the display module 130 is mounted on one side of the door frame 110 in a state that the door cover 140 is mounted on the other side of the door frame 110. The mounting frame 131 is fastened to the door frame 110 by a screw coupling, a hook coupling, a bonding coupling, or the like. For example, a fastening portion 131c formed with a fastening hole is provided on the mounting frame 131, and a fastening member 139a may be screw-coupled to the door frame 110 through the fastening hole.

As illustrated in the present embodiment, when a door frame 110 includes an outer frame 111, an inner frame 112, and a frame cover 150, the door cover 140 is mounted on a front surface of the outer frame 111, and the mounting frame 131 is mounted on a rear surface of the outer frame 111 to correspond to the second opening portion 111b.

When the mounting frame 131 is mounted on a rear surface of the outer frame, as will be described below, it has a structural advantage in that when the frame cover display portion 150 is separated and the display module 130 is exposed to a rear side of the door 10, the fastening member 139a fastened to the mounting frame 131 is separated to completely take out the display module 130 to an outside. In other words, according to a structure in which the mounting frame 131 is mounted on a rear surface of the outer frame 111, a repair work of the display module 130 may be easily carried out.

The display sealing member 133 is configured to seal a gap between the mounting frame 131 and the outer frame 111 when the mounting frame 131 is mounted on the outer frame 111. The display sealing member 133 is closely adhered to a mounting surface of the outer frame 111 adjacent to the second opening portion 111b, and formed to surround the second opening portion 111b.

In a structure in which the display sealing member 133 is fixed to the mounting frame 131, an accommodation groove 131f is formed on the mounting frame 131, and configured to insert and fix part of the display sealing member 133 to the accommodation groove 131f. Another part of the display sealing member 133 is protruded from the accommodation groove 131f, and brought into contact with (closely adhered to) the door frame 110 when the mounting frame 131 is mounted on the door frame 110. Due to the contact, an inner space of the display sealing member 133 is separated from an outer space thereof, thereby preventing moisture from being infiltrated into the inner space.

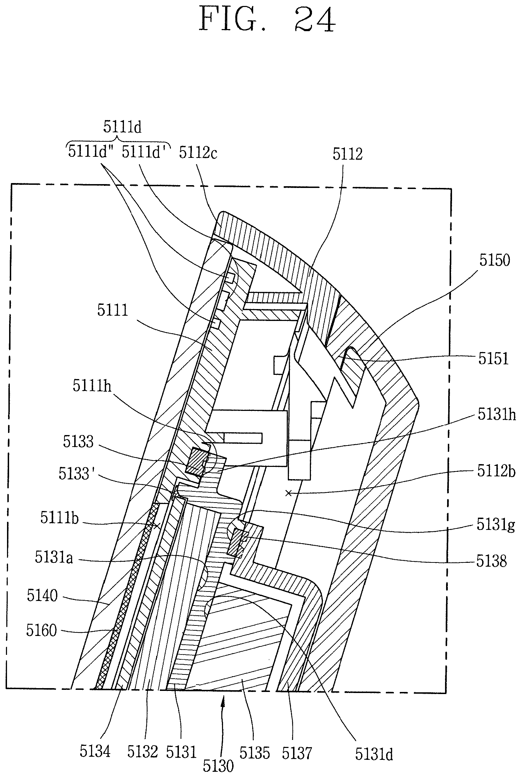

In the above, an example in which the display sealing member 133 is fixed to the mounting frame 131 has been described, but the present disclosure may not be necessarily limited to this. As will be described later in connection with FIG. 24,the display sealing member 133 may be fixed to a rear surface of the outer frame 5111, and in this case, the accommodation groove 5111h for fixing the display sealing member 5133 may be provided on a rear surface of the outer frame 111.

On the other hand, a filler 133' may be filled into a gap between the mounting frame 131 and the display cover 134 in a state that the display 132 is mounted on the display mounting portion 131a. The filler 133' may be configured to fill the gap, thereby preventing moisture from being infiltrated into the display 132 once more.

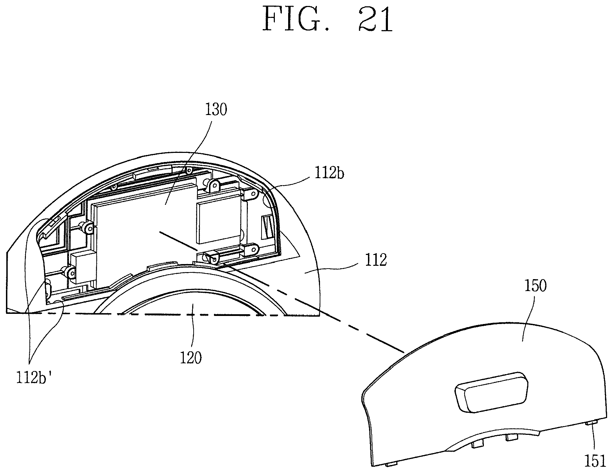

FIG. 21 is a conceptual view illustrating a configuration in which the display module 130 illustrated in FIG. 3 is mounted within the door frame 110.

Referring to FIG. 21 along with the foregoing FIG. 20, the inner frame 112 is coupled to a rear side of the outer frame 111, and disposed to cover the display module 130. In other words, the display module 130 is disposed in an internal space formed by coupling between the outer frame 111 and the inner frame 112.

The communication portion 112b configured to communicate with the internal space is formed on the inner frame 112, and as illustrated in the drawing, the display module 130 may be inserted into the internal space through the communication portion 112b, and then installed on the outer frame 111. A fastening boss corresponding to a fastening portion of the mounting frame 131 is formed on the outer frame 111, and the fastening member 139a is fastened to the fastening boss through the fastening hole of the fastening portion 131c.

On the other hand, the printed circuit board 135 is configured to be electrically connected to a controller (not shown) and a power supply unit (not shown) of the body 20. To this end, a door side cable (not shown) extended from the printed circuit board 135 is connected to a connector (not shown) provided within the outer frame 111, and the connector is electrically connected to a body side cable (not shown) electrically connected to the controller and power supply unit of the body 20.

The door side cable is configured to pass through a through hole (not shown) of the PCB cover 137, and a sealing member (not shown) for sealing may be interposed between the door side cable and the through hole. The sealing member is formed to surround the door side cable, and configured to be closely adhered to an inner circumferential surface of the PCB cover 137 forming the through hole.

The door frame 110 may further include a frame cover 150 disposed to cover the display module 130 in addition to the foregoing outer frame 111 and inner frame 112. The frame cover 150 may be coupled to a rear side of the outer frame 111 along with the inner frame 112 to form a rear appearance of the door 10 along with the door window 120 in a state that the door 10 is opened to open the laundry inlet 20a.

If the inner frame 112 is configured to form an entire rear surface of the door 10 along with the door window 120 without the frame cover 150, then there is a problem in that the entire inner frame 112 should be separated during a repair of the display module 130, and the door window 120 mounted on the opening portion 112a of the inner frame is separated at the same time.

However, when the frame cover 150 is provided as described above, an inner space of the door frame 110 may be opened and closed by a detachable frame cover. In a state that the frame cover display portion 150 is separated, the display module 130 provided in the inner space is exposed to a rear side of the door 10. Accordingly, when it is needed to make a repair of the display module 130, only the frame cover 130 can be merely separated, thereby more easily carrying out the repair work.

According to the present drawing, it is shown a structure that the communication portion 112b is provided at the inner frame 112, and the frame cover 150 is detachably coupled to the communication portion 112b. The frame cover 150 configured to open and close the communication portion 112b is detachably coupled to the inner frame 112. The frame cover 150 is fastened to the inner frame 112 by a screw coupling, a hook coupling, or the like. As illustrated in the drawing, an engagement hook 151 is protruded on the frame cover 150, and an engagement hole (or engagement groove) 112b' configured to be engaged with the engagement hook 151 may be formed on the inner frame 112.

Hereinafter, a modified example of the foregoing laundry treating apparatus will be described. The detailed structured of the foregoing door will be applicable as a whole to the following door unless it contradicts to the detailed description of the following door. Accordingly, the redundant description thereof will be omitted.

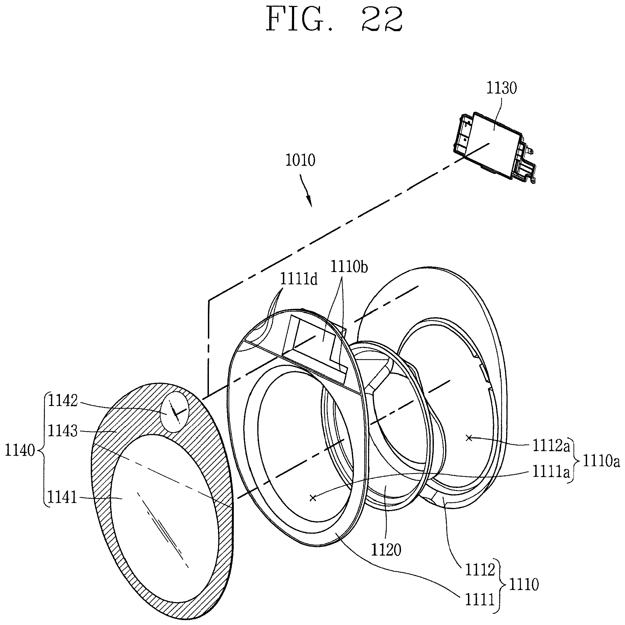

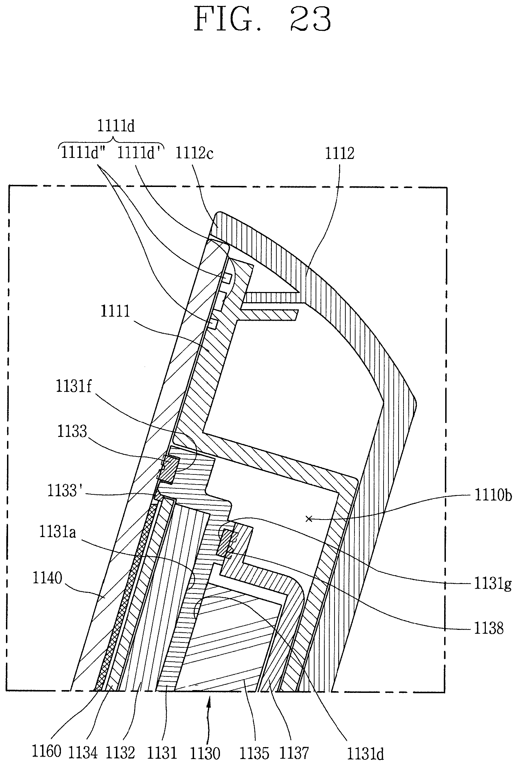

FIG. 22 is an exploded perspective view of a door 1010 according to a modified example of the present disclosure, and FIG. 23 is a cross-sectional view of the door 1010 illustrated in FIG. 22.

Referring to FIGS. 22 and 23, the door 1010 includes a door cover 1140, a display module 1130 and a door frame 1110.

The door cover 1140 may include a non-light-transmitting region 1143 and a first light transmitting region 1141 and a second light transmitting region 1142 within the non-light-transmitting region 1143. The first and the second light transmitting region 1141, 1142 may be divided from each other by the non-light-transmitting region 1143.

The display module 1130 is disposed on a rear surface of the door cover 1140. The display module 1130 is configured to display visual information through the second light transmitting region 1142. The display module 1130 may be directly adhered to a rear surface of the door cover 1140 or mounted on the display module accommodation portion 1110b of the following doorframe 1110.

The door frame 1110 is coupled to the door cover 1140, and connected to the body 20 in a relatively movable manner. The door frame 1110 may be configured to rotate with respect to the body 20 by the hinge unit 30.

The door frame 1110 may include an outer frame 1111 and an inner frame 1112. The outer frame 1111 and inner frame 1112 may be formed of a synthetic resin material (for example, ABS material, PC material, etc.).

The door frame 1110 may include a display module accommodation module 1110b and an opening portion 1110a.

The display module accommodation module 1110b as a recessed space is configured to accommodate the display module 1130. The display module accommodation module 1110b may be configured with a recessed groove formed on the outer frame 1111 itself, and configured to with a recessed space formed to allow the inner frame 1112 to cover a hole formed on the outer frame 1111. The display module accommodation module 1110b may be configured to accommodate a flexible printed circuit board 1161 of the touch sensor 1160.

According to the foregoing configuration, the display module 1130 has a shape covered by the display module accommodation module 1110b. In other words, the display module 1130 is disposed between the door cover 1140 and the door frame 1110. As described above, according to the present modified example, contrary to the foregoing embodiment, there is a structural difference in the aspect that a second opening portion corresponding to the display module 1130 is not provided, and the frame cover is not provided on the door frame 1110.

The easiness of the structure decreases compared to the foregoing embodiment in the aspect of its repair work, but there is an advantage capable of reducing a thickness of the door 10 in the aspect of directly adhering the mounting frame 1131 to the door cover 1140. Furthermore, there is an advantage in the aspect of promoting the enhancement of watertight performance by a combination of the display sealing member 1133 for sealing a gap between the door cover 1140 and the mounting frame 1131 and sealant filled into the sealant filling groove 1111d which will be described below.

The opening portion 1110a is disposed to face the laundry inlet 20a in a state that the door 1010 is closed. A light transmitting door window 1120 is installed on the opening portion 1110a, and configured to view the laundry inlet 20a through the door window 1120.

The opening portion 1110a may include a front side opening portion 1111a formed on the outer frame 1111 and a rear side opening portion 1112a formed on the inner frame 1112.

A sealant filling groove 1111d configured to fill sealant for adhesion to the door cover 1140 is formed on a front surface of the door frame 1110.

As described above, the sealant filling groove 1111d may include a connecting groove portion, a first groove portion and a second groove portion. Specifically, the connecting groove portion is formed to cross between the display module accommodation module 1110b and the opening portion 1110a, and the first groove portion is connected to both end portions of the connecting groove portion and formed to surround a circumference of the opening portion 1110a along with the connecting groove portion, and the second groove portion is connected to both end portions of the connecting groove portion and formed to surround a circumference of the display module accommodation module 1110b along with the connecting groove portion.

The sealant filling groove 1111d may further include a bypass groove portion in addition to the foregoing configuration. The bypass groove portion is configured to connect between an arbitrary point on the connecting groove portion and an arbitrary point on the first groove portion within a space formed by the connecting groove portion and the first groove portion.

Furthermore, the sealant filling groove 1111d may include a sealant coating portion 1111d' and a sealant collecting portion 1111d".

Due to the sealant filling groove 1111d, it may be possible to prevent moisture from being infiltrated into the display module 1130 provided between the door cover 1140 and the door frame 1110. Furthermore, the sealant filling groove 1111d may be configured to separately surround the display module accommodation module 1110b and the opening portion 1110a, respectively, thereby preventing moisture from being infiltrated into the display module 1130 through the opening portion 1110a.

Moreover, as illustrated in the drawing, when the display module 1130 has a structure in which the display module 1130 is directly adhered to a rear surface of the door cover 1140, a display sealing member 1133 may be closely adhered to a rear surface of the door cover 1140. Here, the display sealing member 1133 may also function as an adhesive for coupling the display module 1130 to a rear surface of the door cover 1140.

FIGS. 24 through 26 are cross-sectional views illustrating other modified examples of the present disclosure.

The present modified examples have the same solving task as that of the foregoing structure. In other words, a structure which will be described below has a structure capable of preventing moisture from being infiltrated into electronic elements constituting a display portion when the display portion (or touch screen) is formed on a door 5140, 6140, 7140.

FIG. 24 illustrates an example in which the design of the structure disclosed in FIG. 20 is design modified. Referring to the drawing, the door cover 5140 is mounted on a front surface of the outer frame 5111, and the mounting frame 5131 is mounted on a rear surface of the outer frame 5111 to correspond to the second opening portion 5111b.

When the mounting frame 5131 is mounted on the outer frame 5111, the display sealing member 5133 is configured to seal a gap between the mounting frame 5131 and the outer frame 5111.

An accommodation groove 5111h for surrounding the second opening portion 5111b is formed on the outer frame 5111, and configured such that part of the display sealing member 5133 is inserted and fixed to the accommodation groove 5111h. Another part of the display sealing member 5133 is protruded from the accommodation groove 5111h, and brought into contact with (closely adhered to) the mounting frame 5131 when the mounting frame 5131 is mounted on the outer frame 5111. Due to the contact, an inner space of the display sealing member 5133 is separated from an outer space thereof, thereby preventing moisture from being infiltrated into the inner space.

According to the present drawing, it is shown a structure in which an extension portion 5131h of the mounting frame 5131 is extended in a lateral direction to cover a rear surface of the outer frame 5111, and the display sealing member 5133 inserted into the accommodation groove 5111h is brought into contact with (closely adhered to) the extension portion 5131h. The extension portion 5131h may be extended along a circumference of the mounting frame 5131 to correspond to the display sealing member 5133.

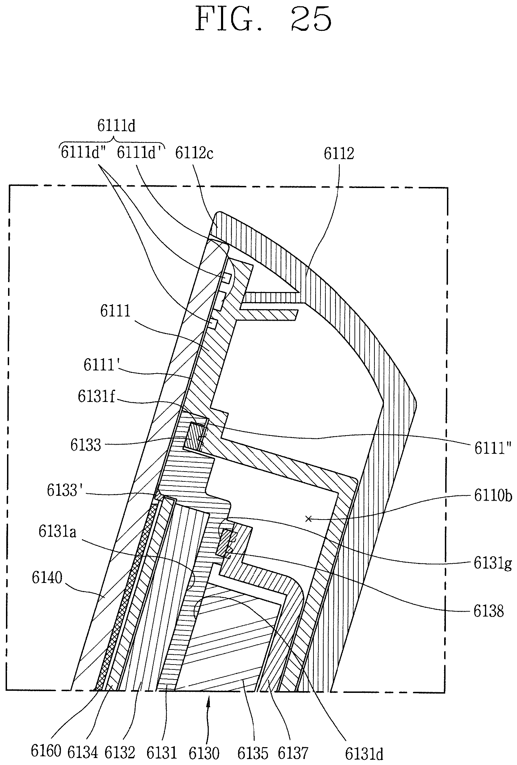

Referring to FIG. 25, the mounting frame 6131 may be mounted on a front surface of the door frame 6110 along with the door cover 6140. Specifically, a first mounting portion 6111' for mounting the door cover 6140 and a second mounting portion 6111" formed in a recessed shape at an inner side of the first mounting portion 6111' to mount the mounting frame 6131. In other words, the second mounting portion 6111" has an inwardly stepped shape with respect to the first mounting portion 6111'.

Due to the structure, the mounting frame 6131 is mounted on the second mounting portion 6111", and then the door cover 6140 is mounted on the first mounting portion 6111'. In other words, the door cover 6140 is disposed to cover the mounting frame 6131 in a state that the door cover 6140 is mounted on the outer frame 6111.

For reference, it is illustrated in the present modified example that a display module accommodation portion 6110b in a recessed shape is provided in the outer frame 6111. The second mounting portion 6111" may be extended in a loop shape to surround the display module accommodation portion 6110b. However, the present disclosure may not be necessarily limited to this. For example, as illustrated in the foregoing embodiment, a second opening portion may be provided in the outer frame 6111 corresponding to the display module 6130.

When the mounting frame 6131 is mounted on the second mounting portion 6111" of the outer frame 6111, the sealing member 6133 is configured to seal a gap between the mounting frame 6131 and the second mounting portion 6111" of the outer frame 6111.

An accommodation groove 6131f is formed in a loop shape corresponding to the second mounting portion 6111" at a portion facing the second mounting portion 6111" on the mounting frame 6131, and configured such that part of the sealing member 6133 is inserted and fixed to the accommodation groove 6131f. Another part of the display sealing member 6133 is protruded from the accommodation groove 6131h, and brought into contact with (closely adhered to) the second mounting portion 6111" when the mounting frame 6131 is mounted on the outer frame 6111.

According to the foregoing structure, when the door cover 6140 is mounted on the first mounting portion 6111', it may be configured that the mounting frame 6131 is pressurized by the door cover 6140 to pressurize the second mounting portion 6111". Due to the foregoing design, an adhesiveness of the sealing member 6133 to the second mounting portion 6111" by the pressurization may be increased to enhance the reliability of the sealing.

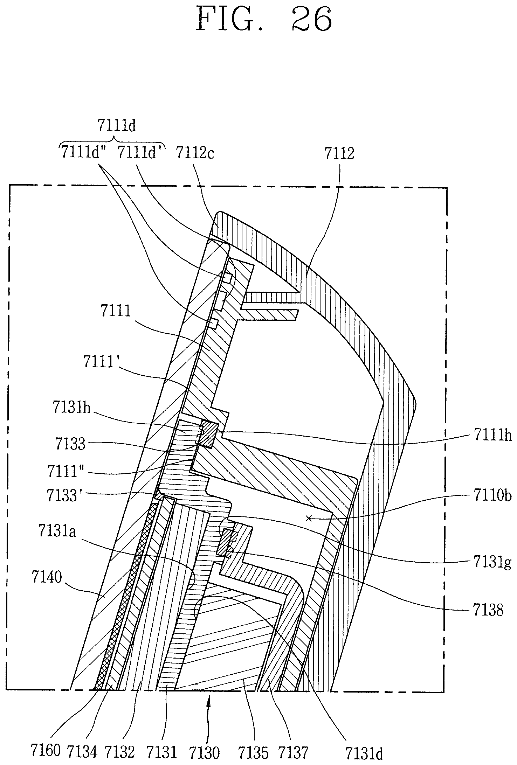

FIG. 26 illustrates a structure in which the formation position of the sealing groove 7111h is interchanged in a structure disclosed in FIG. 25. In other words, the sealing groove 7111h is formed on the second mounting portion 7111" of the outer frame 7111, and extended along the second mounting portion 7111", and configured to surround the display module accommodation portion 7110b.

According to the foregoing structure, part of the display sealing member 7133 is inserted and fixed to the accommodation groove 7111h, and another part of the display sealing member 7133 is protruded from the accommodation groove 7111h, and the mounting frame 7131 is configured to be brought into contact with (closely adhered to) the mounting frame 7131 when the mounting frame 7131 is mounted on the outer frame 7111.

According to the present drawing, it is shown a structure in which an extension portion 7131h of the mounting frame 7131 is extended in a lateral direction to cover the second mounting portion 7111" of the outer frame 7111, and the display sealing member 7133 inserted into the accommodation groove 7111h is brought into contact with (closely adhered to) the extension portion 7131h. The extension portion 7131h may be extended along a circumference of the mounting frame 7131 to correspond to the display sealing member 7133.

According to the foregoing structure, when the door cover 7140 is mounted on the first mounting portion 7111', it may be configured that the mounting frame 7131 is pressurized by the door cover 7140 to pressurize the second mounting portion 7111". Due to the foregoing design, an adhesiveness of the sealing member 7133 to the second mounting portion 7111" by the pressurization may be increased to enhance the reliability of the sealing.

As described above, the display sealing member 5133, 6133, 7133 for sealing a gap between the door frame (outer frame 5111, 6111, 7111 in the modified examples) and the mounting frame 5131, 6131, 7131 may be mounted on the accommodation groove 5111h, 6131f, 7111h formed on either one of the door frame and the mounting frame 5131, 6131, 7131 and closely adhered to the other one thereof. Here, the mounting frame 5131, 6131, 7131 may be coupled to a front surface or rear surface of the door frame.

Furthermore, when the display sealing member 1133 is configured to seal a gap between the door cover 1140 and the mounting frame 1131 as illustrated in a structure disclosed in FIG. 23, for a modified example regarding this, the display sealing member 1133 may be mounted on an accommodation groove formed on the door cover 1140, and brought into contact with (closely adhered to) the mounting frame 1131.

Based on such a technical concept, it should be clearly understood that the foregoing design change may be also applicable to a structure for sealing between the mounting frame 131 and the PCB cover 137. In other words, the PCB sealing member 138 may be mounted on the mounting guide 131g formed on either one of the mounting frame 131 and the PCB cover 137, and brought into contact with (closely adhered to) the other one thereof.

## Claims

1. A laundry treating apparatus (1), comprising:
a body (20) provided with a laundry inlet (20a); and
a door (10) configured to open and close the laundry inlet (20a),
wherein the door (10) comprises:
a door frame (110) having a first opening portion (110a) facing the laundry inlet (20a) when the door (10) is closed and a second opening portion (111b) spaced from the first opening portion (110a);
a door cover (140, 5140) mounted on a front surface of the door frame (110), and provided with a non-light-transmitting region (143), and a first light transmitting region (141) corresponding to the first opening portion (110a) and a second light transmitting region (142) corresponding to the second opening portion (111b) within the non-light-transmitting region (143);
a mounting frame (131, 5131) mounted on a rear surface of the door frame (110) so as to cover the second opening portion (111b);
a display (132, 5132) mounted on the mounting frame (131, 5131) to display visual information through the second light transmitting region (142); and
a display sealing member (133, 5133) disposed between the door frame (110) and the mounting frame (131, 5131), and formed to surround the second opening portion (111b) on a rear surface of the door frame (110); and
a sealant filling groove (111d, 5111d) which forms a space for filling sealant for adhesion with the door cover (140, 5140) on a front surface of the door frame (110), and formed to surround the first opening portion (110a) and the second opening portion (111b), separately, on the front surface of the door frame (110).

2. The laundry treating apparatus of claim 1, wherein an accommodation groove (131f, 5111h) formed to accommodate part of the display sealing member (133, 5133) and surround the display (132, 5132), is formed on either one of the mounting frame (131, 5131) and the door frame (110), and wherein another part of the display sealing member (133, 5133) is formed to be protruded from the accommodation groove (131f, 5111h), and brought into contact with the other one of the mounting frame (131, 5131) and the door frame (110) when the mounting frame (131, 5131) is mounted on the door frame (110).

3. The laundry treating apparatus of claim 2, wherein the display sealing member (133, 5133) is provided with a plurality of contact portions (133a, 133b) brought into contact with the other one of the mounting frame (131, 5131) and the door frame (110), respectively, and
the plurality of contact portions (133a, 133b) are disposed to be separated from each other in a width direction, and extended in parallel along a length direction to form a plurality of sealing loops.

4. The laundry treating apparatus of any one of claims 1 to 3, further comprising:
a display cover (134) formed of a light transmitting material, and disposed to cover the display (132, 5132); and
a filler (133') configured to fill a gap between the mounting frame (131, 5131) and the display cover (134) for preventing moisture from being infiltrated into the display (132, 5132).

5. The laundry treating apparatus of any one of claims 1 to 4, wherein the door frame (110) comprises:
an outer frame (111, 5111) formed with the sealant filling groove (111d, 5111d) on a front surface; and
an inner frame (112, 5112) coupled to a rear side of the outer frame (111, 5111).

6. The laundry treating apparatus of claim 5, wherein a circumferential portion of the inner frame (112, 5112) forms a mounting guide (112c) protruded from a front surface of the outer frame (111, 5111) to surround an outer circumference of the door cover (140, 5140).

7. The laundry treating apparatus of claim 5 or 6, wherein the mounting frame (131, 5131) is mounted on a rear surface of the outer frame (111, 5111), and
a frame cover (150) is mounted at a rear surface side of the outer frame (111, 5111) to cover the mounting frame (131, 5131).

8. The laundry treating apparatus of any one of claims 1 to 7, further comprising:
a touch sensor (160, 5160) adhered to a rear surface of the door cover (140, 5140) to sense a touch input to the second light transmitting region (142).

9. The laundry treating apparatus of claim 8, wherein a FPCB hole (111c) passing through a flexible printed circuit board, FPCB, of the touch sensor (160, 5160) is formed on the door frame (110), and
wherein the display sealing member (133, 5133) is formed to surround the second opening portion (111b) and the FPCB hole (111c).

10. The laundry treating apparatus of claim 9, wherein the display (132, 5132) is mounted at one side of the mounting frame (131, 5131), and a printed circuit board, PCB (135, 5135) electrically connected to the display (132, 5132) and the flexible printed circuit board is mounted at the other side thereof.

11. The laundry treating apparatus of claim 10, wherein a wireless communication module (136) capable of performing wireless communication with an external electronic device is further mounted at the other side of the mounting frame (131, 5131).

12. The laundry treating apparatus of claim 10 or 11, further comprising:
a PCB cover (137, 5137) mounted on the mounting frame (131, 5131) and disposed to cover the printed circuit board (135, 5135); and
a PCB sealing member (138, 5138) disposed between the mounting frame (131, 5131) and the PCB cover (137, 5137) and formed to surround the printed circuit board (131, 5131).

13. The laundry treating apparatus of claim 12, wherein a mounting groove (131g, 5131g) configured to accommodate part of the PCB sealing member (138, 5138), and formed to surround the printed circuit board (135, 5135) is formed on either one of the mounting frame (131, 5131) and the PCB cover (137, 5137), and
wherein another part of the PCB sealing member (138, 5138) is formed to be protruded from the mounting groove (131g, 5131g), and brought into contact with the other one of the mounting frame (131, 5131) and the PCB cover (137, 5137) when the PCB cover (137, 5137) is mounted on the mounting frame (131, 5131).

14. The laundry treating apparatus of claim 13, wherein the PCB sealing member (138, 5138) is provided with a plurality of contact portions (138a, 138b) brought into contact with the other one of the mounting frame (131, 5131) and the PCB cover (137, 5137), respectively, and
the plurality of contact portions (138a, 138b) are disposed to be separated from each other in a width direction, and extended in parallel along a length direction to form a plurality of sealing loops.

15. A laundry treating apparatus (1), comprising:
a body (20) provided with a laundry inlet (20a); and
a door (10) configured to open and close the laundry inlet (20a),
wherein the door (10) comprises:
a door frame (6110) having an opening portion (110a) facing the laundry inlet (20a) when the door (10) is closed and a display module accommodation portion (6110b, 7110b) spaced from the opening portion (110a) and recessed toward a rear side;
a door cover (6140, 7140) mounted to a front surface of the door frame (6110), disposed to cover the opening portion (110a) and the display module accommodation portion (6110b, 7110b), and including a non-light-transmitting region (143), and a first light transmitting region (141) corresponding to the opening portion (110a) and a second light transmitting region (142) corresponding to the display module accommodation portion (6110b, 7110b) within the non-light-transmitting region (143); and
a display module (6130, 7130) accommodated in the display module accommodation portion (6110b, 7110b), provided on a rear surface of the door cover (6140, 7140), and configured to output visual information through the second light transmitting region (142), and
the display module (6130, 7130) comprises:
a mounting frame (6131, 7131) provided with a display mounting portion (6131a, 7131a) and a printed circuit board mounting portion (6131d, 7131d) at both side thereof, respectively;
a PCB cover (6137, 7137) mounted on the mounting frame (6131, 7131) to cover the printed circuit board mounting portion (6131d, 7131d);
a display sealing member (6133, 7133) disposed between the door frame (6110) and the mounting frame (6131, 7131), and formed to surround the display mounting portion (6131a, 7131a); and
a PCB sealing member (6138, 7138) disposed between the mounting frame (6131, 7131) and the PCB cover (6137, 7137), and formed to surround the printed circuit board mounting portion (6131d, 7131d),
wherein a sealant filling groove (6111d, 7111 d) which forms a space for filling sealant for adhesion with the door cover (6140, 7140) is provided on the front surface of the door frame (6110), so as to surround the opening portion (110a) and the display module accommodation portion (6110b, 7110b), separately, and
wherein the display sealing member (6133, 7133) is located within the sealant filling groove (6111d, 7111d) which surrounds the display module accommodation portion (6110b, 7110b).

16. The laundry treating apparatus of claim 15, wherein the door frame (6110) comprises:
a first mounting portion (6111', 7111') formed on a front surface of the door frame (6110), so as to mount the door cover (6140, 7140); and
a second mounting portion (6111", 7111") recessed within the first mounting portion (6111', 7111') so as to mount the mounting frame (6131, 7131), and formed to surround the display accommodation portion (6110b, 7110b), and
wherein the door cover (6140, 7140) is disposed to cover the mounting frame (6131, 7131) in a state that the door cover (6140, 7140) is mounted to the door frame (6110).

17. The laundry treating apparatus of claim 15, wherein an accommodation groove (6131f, 7111h) formed to accommodate part of the display sealing member (6133, 7133) and surround a display (6132, 7132) mounted on the mounting frame (6131, 7131), is formed on either one of the mounting frame (6131, 7131) and the door frame (6110), and
wherein another part of the display sealing member (6133, 7133) is formed to be protruded from the accommodation groove (6131f, 7131f), and brought into contact with the other one of the mounting frame (6131, 7131) and the door frame (6110) when the mounting frame (6131, 7131) is mounted to the door frame (6110).

18. The laundry treating apparatus of claim 17, wherein the display sealing member (6133, 7133) is provided with a plurality of contact portions (133a, 133b) brought into contact with the other one of the mounting frame (6131, 7131) and the door frame (6110), respectively, and
the plurality of contact portions (133a, 133b) are disposed to be separated from each other in a width direction, and extended in parallel along a length direction to form a plurality of sealing loops.

19. The laundry treating apparatus of any one of claims 15 to 18, wherein the PCB sealing member (6138, 7138) is provided with a plurality of contact portions (138a, 138b) brought into contact with the PCB cover (6137, 7137), respectively, and
the plurality of contact portions (138a, 138b) are disposed to be separated from each other in a width direction, and extended in parallel along a length direction to form a plurality of sealing loops.

20. The laundry treating apparatus of any one of claims 15 to 19, wherein the door frame (6110) comprises:
an outer frame (6111, 7111) formed with the sealant filling groove (6111 d, 7111d) to fill sealant for adhesion to the door cover (6140, 7140) on a front surface; and
an inner frame (6112, 7112) coupled to a rear side of the outer frame (6111, 71111).

21. The laundry treating apparatus of claim 20, wherein the mounting frame (6131, 7131) is configured to be mounted on a front surface of the outer frame (6111, 7111) and covered by the door cover (6140, 7140), and
sealant filled into the sealant filling groove (6111d, 7111d) is configured to surround the display sealing member (6133, 7133).

22. A laundry treating apparatus (1), comprising:
a body (20) provided with a laundry inlet (20a); and
a door (1010) configured to open and close the laundry inlet (20a),
wherein the door (1010) comprises:
a door frame (1110) having an opening portion (1110a) facing the laundry inlet (20a) when the door (1010) is closed and a display module accommodation portion (1110b) spaced from the opening portion (1110a) and recessed toward a rear side;
a door cover (140) mounted to a front surface of the door frame (1110), disposed to cover the opening portion (1110a) and the display module accommodation portion (1110b), and including a non-light-transmitting region (1143), and a first light transmitting region (1141) corresponding to the opening portion (1110a) and a second light transmitting region (1142) corresponding to the display module accommodation portion (1110b) within the non-light-transmitting region (1143); and
a display module (1130) accommodated in the display module accommodation portion (1110b), provided on a rear surface of the door cover (1110a), and configured to output visual information through the second light transmitting region (1142), and
a display sealing member (1133) is configured to surround a display (1132) provided in the display module (1130) between the door cover (1140) and the display module (1130),
wherein a sealant filling groove (1111d) which forms a space for filling sealant for adhesion with the door cover (1140) is provided on a front surface of the door frame (1110), so as to surround the opening portion (1110a) and the display module accommodation portion (1110b), separately, and
wherein the display sealing member (1133) is located within the sealant filling groove (1111d) which surrounds the display module accommodation portion (1110b).

## Patentansprüche

1. Wäschebehandlungsvorrichtung (1), mit:
einem Körper (20) mit einem Wäscheeinlass (20a); und
einer Tür (10), die dafür konfiguriert ist, den Wäscheeinlass (20a) zu öffnen und zu schließen, wobei die Tür (10) aufweist:
einen Türrahmen (110) mit einem ersten Öffnungsabschnitt (110a), der dem Wäscheeinlass (20a) zugewandt ist, wenn die Tür (10) geschlossen ist, und einem zweiten Öffnungsabschnitt (111b), der vom ersten Öffnungsabschnitt (110a) beabstandet ist;
eine Türabdeckung (140, 5140), die an einer Vorderfläche des Türrahmens (110) montiert ist und einen lichtundurchlässigen Bereich (143) und einen ersten lichtdurchlässigen Bereich (141), der dem ersten Öffnungsabschnitt (110a) entspricht, und einen zweiten lichtdurchlässigen Bereich (142), der dem zweiten Öffnungsabschnitt (111b) entspricht, innerhalb des lichtundurchlässigen Bereichs (143) aufweist;
einen Montagerahmen (131, 5131), der an einer hinteren Fläche des Türrahmens (110) derart montiert ist, dass er den zweiten Öffnungsabschnitt (111b) abdeckt;
eine Anzeige (132, 5132), die am Montagerahmen (131, 5131) montiert ist, um visuelle Information durch den zweiten lichtdurchlässigen Bereich (142) anzuzeigen; und
ein Anzeigedichtungselement (133, 5133), das zwischen dem Türrahmen (110) und dem Montagerahmen (131, 5131) angeordnet und derart ausgebildet ist, dass es den zweiten Öffnungsabschnitt (111b) auf einer hinteren Fläche des Türrahmens (110) umgibt; und
eine Dichtmittelfüllnut (111d, 5111d), die einen Raum zum Einfüllen eines Dichtmittels zum Verkleben mit der Türabdeckung (140, 5140) auf einer Vorderfläche des Türrahmens (110) bildet und derart ausgebildet ist, dass sie den ersten Öffnungsabschnitt (110a) und den zweiten Öffnungsabschnitt (111b) separat auf der Vorderfläche des Türrahmens (110) umgibt.

2. Wäschebehandlungsvorrichtung nach Anspruch 1, wobei eine Aufnahmenut (131f, 5111h), die derart ausgebildet ist, dass sie einen Teil des Anzeigedichtungselements (133, 5133) aufnimmt und die Anzeige (132, 5132) umgibt, an einer Komponente unter dem Montagerahmen (131, 5131) und dem Türrahmen (110) ausgebildet ist, und wobei ein anderer Teil des Anzeigedichtungselements (133, 5133) derart ausgebildet ist, dass er von der Aufnahmenut (131f, 5111h) hervorsteht und mit der anderen Komponente unter dem Montagerahmen (131, 5131) und dem Türrahmen (110) in Kontakt gebracht wird, wenn der Montagerahmen (131, 5131) am Türrahmen (110) montiert wird.

3. Wäschebehandlungsvorrichtung nach Anspruch 2, wobei das Anzeigedichtungselement (133, 5133) mehrere Kontaktabschnitte (133a, 133b) aufweist, die mit der anderen Komponente unter dem Montagerahmen (131, 5131) und dem Türrahmen (110) in Kontakt gebracht werden, und
die mehreren Kontaktabschnitte (133a, 133b) derart angeordnet sind, dass sie in einer Breitenrichtung voneinander getrennt sind und sich parallel entlang einer Längsrichtung erstrecken, um mehrere Dichtungsschleifen zu bilden.

4. Wäschebehandlungsvorrichtung nach einem der Ansprüche 1 bis 3, ferner mit:
einer Anzeigeabdeckung (134), die aus einem lichtdurchlässigen Material ausgebildet und derart angeordnet ist, dass sie die Anzeige (132, 5132) abdeckt; und
einem Füllmittel (133'), das dafür konfiguriert ist, einen Spalt zwischen dem Montagerahmen (131, 5131) und der Anzeigeabdeckung (134) zu füllen, um zu verhindern, dass Feuchtigkeit in die Anzeige (132, 5132) eindringt.

5. Wäschebehandlungsvorrichtung nach einem der Ansprüche 1 bis 4, wobei der Türrahmen (110) aufweist:
einen äußeren Rahmen (111, 5111), in dem eine Dichtmittelfüllnut (111d, 5111d) auf einer Vorderfläche ausgebildet ist; und
einen inneren Rahmen (112, 5112), der mit einer Rückseite des äußeren Rahmens (111, 5111) verbunden ist.

6. Wäschebehandlungsvorrichtung nach Anspruch 5, wobei ein Umfangsabschnitt des inneren Rahmens (112, 5112) eine Montageführung (112c) bildet, die von einer Vorderfläche des äußeren Rahmens (111, 5111) derart hervorsteht, dass sie einen Außenumfang der Türabdeckung (140, 5140) umgibt.

7. Wäschebehandlungsvorrichtung nach Anspruch 5 oder 6, wobei der Montagerahmen (131, 5131) an einer Rückfläche des äußeren Rahmens (111, 5111) montiert ist, und
eine Rahmenabdeckung (150) an einer Rückfläche des äußeren Rahmens (111, 5111) derart montiert ist, dass sie den Montagerahmen (131, 5131) abdeckt.

8. Wäschebehandlungsvorrichtung nach einem der Ansprüche 1 bis 7, ferner mit einem Berührungssensor (160, 5160), der an einer Rückfläche der Türabdeckung (140, 5140) angeklebt ist, um eine Berührungseingabe im zweiten lichtdurchlässigen Bereich (142) zu erfassen.

9. Wäschebehandlungsvorrichtung nach Anspruch 8, wobei ein FPCB-Loch (111c), das sich durch eine flexible Leiterplatte, FPCB, des Berührungssensors (160, 5160) erstreckt, am Türrahmen (110) ausgebildet ist, und
wobei das Anzeigedichtungselement (133, 5133) derart ausgebildet ist, dass es den zweiten Öffnungsabschnitt (111b) und das FPCB-Loch (111c) umgibt.

10. Wäschebehandlungsvorrichtung nach Anspruch 9, wobei die Anzeige (132, 5132) an einer Seite des Montagerahmens (131, 5131) montiert ist und eine Leiterplatte, PCB (135, 5135), die elektrisch mit der Anzeige (132, 5132) und der flexiblen Leiterplatte verbunden ist, an der anderen Seite davon montiert ist.

11. Wäschebehandlungsvorrichtung nach Anspruch 10, wobei ferner ein Drahtloskommunikationsmodul (136), das in der Lage ist, eine Drahtloskommunikation mit einem externen elektronischen Gerät auszuführen, an der anderen Seite des Montagerahmens (131, 5131) montiert ist.

12. Wäschebehandlungsvorrichtung nach Anspruch 10 oder 11, ferner mit:
einer Leiterplattenabdeckung (137, 5137), die am Montagerahmen (131, 5131) montiert und derart angeordnet ist, dass sie die Leiterplatte (135, 5135) abdeckt; und
einem Leiterplattendichtungselement (138, 5138), das zwischen dem Montagerahmen (131, 5131) und der Leiterplattenabdeckung (137, 5137) angeordnet und derart ausgebildet ist, dass es die Leiterplatte (131, 5131) umgibt.

13. Wäschebehandlungsvorrichtung nach Anspruch 12, wobei eine Montagenut (131g, 5131g), die dafür konfiguriert ist, einen Teil des Leiterplattendichtungselements (138, 5138) aufzunehmen, und die so ausgebildet ist, dass sie die Leiterplatte (135, 5135) umgibt, an einer Komponente unter dem Montagerahmen (131, 5131) und der Leiterplattenabdeckung (137, 5137) ausgebildet ist, und
wobei ein anderer Teil des Leiterplattendichtungselements (138, 5138) derart ausgebildet ist, dass er von der Montagenut (131g, 5131g) hervorsteht und in Kontakt mit der anderen Komponente unter dem Montagerahmen (131, 5131) und der Leiterplattenabdeckung (137, 5137) gebracht wird, wenn die Leiterplattenabdeckung (137, 5137) am Montagerahmen (131, 5131) montiert wird.

14. Wäschebehandlungsvorrichtung nach Anspruch 13, wobei das Leiterplattendichtungselement (138, 5138) mehrere Kontaktabschnitte (138a, 138b) aufweist, die in Kontakt mit der anderen Komponente unter dem Montagerahmen (131, 5131) und der Leiterplattenabdeckung (137, 5137) gebracht werden, und
die mehreren Kontaktabschnitte (138a, 138b) derart angeordnet sind, dass sie in einer Breitenrichtung voneinander getrennt sind und sich parallel entlang einer Längsrichtung erstrecken, um mehrere Dichtungsschleifen zu bilden.

15. Wäschebehandlungsvorrichtung (1) mit:
einem Körper (20) mit einem Wäscheeinlass (20a); und
einer Tür (10), die dafür konfiguriert ist, den Wäscheeinlass (20a) zu öffnen und zu schließen, wobei die Tür (10) aufweist:
einen Türrahmen (6110) mit einem Öffnungsabschnitt (110a), der dem Wäscheeinlass (20a) zugewandt ist, wenn die Tür (10) geschlossen ist, und einem Anzeigemodulaufnahmeabschnitt (6110b, 7110b), der vom Öffnungsabschnitt (110a) beabstandet und zu einer Rückseite hin vertieft ist;
eine Türabdeckung (6140, 7140), die an einer Vorderfläche des Türrahmens (6110) montiert und derart angeordnet ist, dass sie den Öffnungsabschnitt (110a) und den Anzeigemodulaufnahmeabschnitt (6110b, 7110b) abdeckt, und einen lichtundurchlässigen Bereich (143) und einen ersten lichtdurchlässigen Bereich (141), der dem Öffnungsabschnitt (110a) entspricht, und einen zweiten lichtdurchlässigen Bereich (142), der dem Anzeigemodulaufnahmeabschnitt (6110b, 7110b) entspricht, innerhalb des lichtundurchlässigen Bereichs (143) aufweist; und
ein Anzeigemodul (6130, 7130), das im Anzeigemodulaufnahmeabschnitt (6110b, 7110b) aufgenommen ist, auf einer Rückfläche der Türabdeckung (6140, 7140) angeordnet und dafür konfiguriert ist, visuelle Information durch den zweiten lichtdurchlässigen Bereich (142) auszugeben, und
wobei das Anzeigemodul (6130, 7130) aufweist:
einen Montagerahmen (6131, 7131), der einen Anzeigemontageabschnitt (6131a, 7131a) und einen Leiterplattenmontageabschnitt (6131d, 7131d) an seinen beiden Seiten aufweist;
eine Leiterplattenabdeckung (6137, 7137), die am Montagerahmen (6131, 7131) montiert ist, um den Leiterplattenmontageabschnitt (6131d, 7131d) abzudecken;
ein Anzeigedichtungselement (6133, 7133), das zwischen dem Türrahmen (6110) und dem Montagerahmen (6131, 7131) angeordnet und derart ausgebildet ist, dass es den Anzeigemontageabschnitt (6131a, 7131a) umgibt; und
ein Leiterplattendichtungselement (6138, 7138), das zwischen dem Montagerahmen (6131, 7131) und der Leiterplattenabdeckung (6137, 7137) angeordnet und derart ausgebildet ist, dass es den Leiterplattenmontageabschnitt (6131d, 7131d) umgibt,
wobei eine Dichtmittelfüllnut (6111d, 7111d), die einen Raum zum Einfüllen eines Dichtmittels zum Verkleben mit der Türabdeckung (6140, 7140) bildet, an der Vorderfläche des Türrahmens (6110) derart bereitgestellt ist, dass sie den Öffnungsabschnitt (110a) und den Anzeigemodulaufnahmeabschnitt (6110b, 7110b) separat umgibt, und
wobei das Anzeigedichtungselement (6133, 7133) innerhalb der Dichtmittelfüllnut (6111d, 7111d) angeordnet ist, die den Anzeigemodulaufnahmeabschnitt (6110b, 7110b) umgibt.

16. Wäschebehandlungsvorrichtung nach Anspruch 15, wobei der Türrahmen (6110) aufweist:
einen an einer Vorderfläche des Türrahmens (6110) ausgebildeten ersten Montageabschnitt (6111', 7111') zum Montieren der Türabdeckung (6140, 7140); und
einen zweiten Montageabschnitt (6111", 7111"), der innerhalb des ersten Montageabschnitts (6111', 7111') vertieft ausgebildet ist, zum Montieren des Montagerahmens (6131, 7131), und derart ausgebildet ist, dass er den Anzeigeaufnahmeabschnitt (6110b, 7110b) umgibt, und
wobei die Türabdeckung (6140, 7140) derart angeordnet ist, dass sie den Montagerahmen (6131, 7131) in einem Zustand abdeckt, in dem die Türabdeckung (6140, 7140) am Türrahmen (6110) montiert ist.

17. Wäschebehandlungsvorrichtung nach Anspruch 15, wobei eine Aufnahmenut (6131f, 7111h), die dazu ausgebildet ist, einen Teil des Anzeigedichtungselements (6133, 7133) aufzunehmen und eine Anzeige (6132, 7132) zu umgeben, die am Montagerahmen (6131, 7131) montiert ist, auf einer Komponente unter dem Montagerahmen (6131, 7131) und dem Türrahmen (6110) ausgebildet ist, und
wobei ein anderer Teil des Anzeigedichtungselements (6133, 7133) derart ausgebildet ist, dass er von der Aufnahmenut (6131f, 7131f) hervorsteht und in Kontakt mit der anderen Komponente unter dem Montagerahmen (6131, 7131) und dem Türrahmen (6110) gebracht wird, wenn der Montagerahmen (6131, 7131) am Türrahmen (6110) montiert wird.

18. Wäschebehandlungsvorrichtung nach Anspruch 17, wobei das Anzeigedichtungselement (6133, 7133) mehrere Kontaktabschnitte (133a, 133b) aufweist, die mit der anderen Komponente unter dem Montagerahmen (6131, 7131) und dem Türrahmen (6110) in Kontakt gebracht werden, und
die mehreren Kontaktabschnitte (133a, 133b) derart angeordnet sind, dass sie in einer Breitenrichtung voneinander getrennt sind und sich parallel entlang einer Längsrichtung erstrecken, um mehrere Dichtungsschleifen zu bilden.

19. Wäschebehandlungsvorrichtung nach einem der Ansprüche 15 bis 18, wobei das Leiterplattendichtungselement (6138, 7138) mehrere Kontaktabschnitte (138a, 138b) aufweist, die jeweils in Kontakt mit der Leiterplattendichtungsabdeckung (6137, 7137) gebracht werden, und
die mehreren Kontaktabschnitte (138a, 138b) derart angeordnet sind, dass sie in einer Breitenrichtung voneinander getrennt sind und sich parallel entlang einer Längsrichtung erstrecken, um mehrere Dichtungsschleifen zu bilden.

20. Wäschebehandlungsvorrichtung nach einem der Ansprüche 15 bis 19, wobei der Türrahmen (6110) aufweist:
einen äußeren Rahmen (6111, 7111), in dem die Dichtmittelfüllnut (6111d, 7111d) zum Einfüllen eines Dichtmittels zum Ankleben an die Türabdeckung (6140, 7140) auf einer Vorderfläche ausgebildet ist; und
einen inneren Rahmen (6112, 7112), der mit einer Rückseite des äußeren Rahmens (6111, 7111) verbunden ist.

21. Wäschebehandlungsvorrichtung nach Anspruch 20, wobei der Montagerahmen (6131, 7131) dafür konfiguriert ist, an einer Vorderfläche des äußeren Rahmens (6111, 7111) montiert und durch die Türabdeckung (6140, 7140) abgedeckt zu werden, und
das in die Dichtmittelfüllnut (6111d, 7111d) eingefüllte Dichtmittel derart konfiguriert ist, dass es das Anzeigedichtungselement (6133, 7133) umgibt.

22. Wäschebehandlungsvorrichtung (1), mit:
einem Körper (20) mit einem Wäscheeinlass (20a); und
einer Tür (1010), die dafür konfiguriert ist, den Wäscheeinlass (20a) zu öffnen und zu schließen,
wobei die Tür (1010) aufweist:
einen Türrahmen (1110) mit einem Öffnungsabschnitt (1110a), der dem Wäscheeinlass (20a) zugewandt ist, wenn die Tür (10) geschlossen ist, und einem Anzeigemodulaufnahmeabschnitt (1110b), der vom Öffnungsabschnitt (1110a) beabstandet ist;
eine Türabdeckung (140), die an einer Vorderfläche des Türrahmens (1110) montiert ist, derart angeordnet ist, dass sie den Öffnungsabschnitt (1110a) und den Anzeigemodulaufnahmeabschnitt (1110b) abdeckt, und einen lichtundurchlässigen Bereich (1143) und einen ersten lichtdurchlässigen Bereich (1141), der dem Öffnungsabschnitt (1110a) entspricht, und einen zweiten lichtdurchlässigen Bereich (1142), der dem Anzeigemodulaufnahmeabschnitt (1110b) entspricht, innerhalb des lichtundurchlässigen Bereichs (1143) aufweist;
ein Anzeigemodul (1130), das im Anzeigemodulaufnahmeabschnitt (1110b) aufgenommen ist, an einer Rückfläche der Türabdeckung (1110a) angeordnet und dafür konfiguriert ist, visuelle Information durch den zweiten lichtdurchlässigen Bereich (1142) auszugeben; und
ein Anzeigedichtungselement (1133), das dafür konfiguriert ist, eine im Anzeigemodul (1130) vorgesehene Anzeige (1132) zwischen der Türabdeckung (1140) und dem Anzeigemodul (1130) zu umgeben,
wobei eine Dichtmittelfüllnut (1111d), die einen Raum zum Einfüllen eines Dichtmittels zum Verkleben mit der Türabdeckung (1140) bildet, auf einer Vorderfläche des Türrahmens (1110) derart angeordnet ist, dass sie den Öffnungsabschnitt (1110a) und den Anzeigemodulaufnahmeabschnitt (1110b) separat umgibt, und
wobei das Anzeigedichtungselement (1133) innerhalb der Dichtmittelfüllnut (1111d) angeordnet ist, die den Anzeigemodulaufnahmeabschnitt (1110b) umgibt.

## Revendications

1. Appareil de traitement de linge (1), comprenant :
un corps (20) muni d'une entrée de linge (20a) ; et
une porte (10) configurée pour ouvrir et fermer l'entrée de linge (20a),
dans lequel la porte (10) comprend :
un cadre de porte (110) ayant une première portion d'ouverture (110a) face à l'entrée de linge (20a) lorsque la porte (10) est fermée et une seconde portion d'ouverture (111b) espacée de la première portion d'ouverture (110a) ;
un couvercle de porte (140, 5140) monté sur une surface avant du cadre de porte (110), et muni d'une région de non-transmission de lumière (143), et d'une première région de transmission de lumière (141) correspondant à la première portion d'ouverture (110a) et d'une seconde région de transmission de lumière (142) correspondant à la seconde portion d'ouverture (111b) au sein de la région de non-transmission de lumière (143) ;
un cadre de montage (131, 5131) monté sur une surface arrière du cadre de porte (110) de façon à couvrir la seconde portion d'ouverture (111b) ;
un afficheur (132, 5132) monté sur le cadre de montage (131, 5131) pour afficher des informations visuelles à travers la seconde région de transmission de lumière (142) ; et
un organe d'étanchéité d'afficheur (133, 5133) disposé entre le cadre de porte (110) et le cadre de montage (131, 5131), et formé pour entourer la seconde portion d'ouverture (111b) sur une surface arrière du cadre de porte (110) ; et
une rainure de remplissage d'agent d'étanchéité (111d, 5111d) qui forme un espace à remplir d'agent d'étanchéité pour une adhérence avec le couvercle de porte (140, 5140) sur une surface avant du cadre de porte (110), et formée pour entourer la première portion d'ouverture (110a) et la seconde portion d'ouverture (111b), séparément, sur la surface avant du cadre de porte (110).

2. Appareil de traitement de linge selon la revendication 1, dans lequel une rainure de logement (131f, 5111h) formée pour loger une partie de l'organe d'étanchéité d'afficheur (133, 5133) et entourer l'afficheur (132, 5132), est formée sur l'un ou l'autre du cadre de montage (131, 5131) et du cadre de porte (110), et dans lequel une autre partie de l'organe d'étanchéité d'afficheur (133, 5133) est formée pour être mise en saillie depuis la rainure de logement (131f, 5111h), et mise en contact avec l'autre du cadre de montage (131, 5131) et du cadre de porte (110) lorsque le cadre de montage (131, 5131) est monté sur le cadre de porte (110).

3. Appareil de traitement de linge selon la revendication 2, dans lequel l'organe d'étanchéité d'afficheur (133, 5133) est muni d'une pluralité de portions de contact (133a, 133b) mises en contact avec l'autre du cadre de montage (131, 5131) et du cadre de porte (110), respectivement, et
la pluralité de portions de contact (133a, 133b) sont disposées pour être séparées l'une de l'autre dans une direction de largeur, et étendues en parallèle suivant une direction de longueur pour former une pluralité de boucles d'étanchéité.

4. Appareil de traitement de linge selon l'une quelconque des revendications 1 à 3, comprenant en outre :
un couvercle d'afficheur (134) formé d'un matériau de transmission de lumière, et disposé pour couvrir l'afficheur (132, 5132) ; et
un agent de remplissage (133') configuré pour remplir un écartement entre le cadre de montage (131, 5131) et le couvercle d'afficheur (134) afin d'empêcher l'humidité de s'infiltrer dans l'afficheur (132, 5132).

5. Appareil de traitement de linge selon l'une quelconque des revendications 1 à 4, dans lequel le cadre de porte (110) comprend :
un cadre extérieur (111, 5111) formé avec la rainure de remplissage d'agent d'étanchéité (111d, 5111d) sur une surface avant ; et
un cadre intérieur (112, 5112) couplé à un côté arrière du cadre extérieur (111, 5111).

6. Appareil de traitement de linge selon la revendication 5, dans lequel une portion circonférentielle du cadre intérieur (112, 5112) forme un guide de montage (112c) mis en saillie depuis une surface avant du cadre extérieur (111, 5111) pour entourer une circonférence extérieure du couvercle de porte (140, 5140).

7. Appareil de traitement de linge selon la revendication 5 ou 6, dans lequel le cadre de montage (131, 5131) est monté sur une surface arrière du cadre extérieur (111, 5111), et
un couvercle de cadre (150) est monté au niveau d'un côté surface arrière du cadre extérieur (111, 5111) pour couvrir le cadre de montage (131, 5131).

8. Appareil de traitement de linge selon l'une quelconque des revendications 1 à 7, comprenant en outre :
un capteur tactile (160, 5160) mis à adhérer à une surface arrière du couvercle de porte (140, 5140) pour capter une entrée tactile sur la seconde région de transmission de lumière (142).

9. Appareil de traitement de linge selon la revendication 8, dans lequel un trou de FPCB (111c) passant à travers une carte de circuit imprimé flexible, FPCB, du capteur tactile (160, 5160) est formé sur le cadre de porte (110), et
dans lequel l'organe d'étanchéité d'afficheur (133, 5133) est formé pour entourer la seconde portion d'ouverture (111b) et le trou de FPCB (111c).

10. Appareil de traitement de linge selon la revendication 9, dans lequel l'afficheur (132, 5132) est monté au niveau d'un côté du cadre de montage (131, 5131), et une carte de circuit imprimé, PCB (135, 5135) connectée électriquement à l'afficheur (132, 5132) et à la carte de circuit imprimé flexible est montée au niveau de son autre côté.

11. Appareil de traitement de linge selon la revendication 10, dans lequel un module de communication sans fil (136) capable de réaliser une communication sans fil avec un dispositif électronique externe est en outre monté au niveau de l'autre côté du cadre de montage (131, 5131).

12. Appareil de traitement de linge selon la revendication 10 ou 11, comprenant en outre :
un couvercle de PCB (137, 5137) monté sur le cadre de montage (131, 5131) et disposé pour couvrir la carte de circuit imprimé (135, 5135) ; et
un organe d'étanchéité de PCB (138, 5138) disposé entre le cadre de montage (131, 5131) et le couvercle de PCB (137, 5137) et formé pour entourer la carte de circuit imprimé (131, 5131).

13. Appareil de traitement de linge selon la revendication 12, dans lequel une rainure de montage (131g, 5131g) configurée pour loger une partie de l'organe d'étanchéité de PCB (138, 5138), et formée pour entourer la carte de circuit imprimé (135, 5135) est formée sur l'un ou l'autre du cadre de montage (131, 5131) et du couvercle de PCB (137, 5137), et
dans lequel une autre partie de l'organe d'étanchéité de PCB (138, 5138) est formée pour être mise en saillie depuis la rainure de montage (131g, 5131g), et mise en contact avec l'autre du cadre de montage (131, 5131) et du couvercle de PCB (137, 5137) lorsque le couvercle de PCB (137, 5137) est monté sur le cadre de montage (131, 5131).

14. Appareil de traitement de linge selon la revendication 13, dans lequel l'organe d'étanchéité de PCB (138, 5138) est muni d'une pluralité de portions de contact (138a, 138b) mises en contact avec l'autre du cadre de montage (131, 5131) et du couvercle de PCB (137, 5137), respectivement, et
la pluralité de portions de contact (138a, 138b) sont disposées pour être séparées l'une de l'autre dans une direction de largeur, et étendues en parallèle suivant une direction de longueur pour former une pluralité de boucles d'étanchéité.

15. Appareil de traitement de linge (1), comprenant :
un corps (20) muni d'une entrée de linge (20a) ; et
une porte (10) configurée pour ouvrir et fermer l'entrée de linge (20a),
dans lequel la porte (10) comprend :
un cadre de porte (6110) ayant une portion d'ouverture (110a) face à l'entrée de linge (20a) lorsque la porte (10) est fermée et une portion de logement de module d'affichage (6110b, 7110b) espacée de la portion d'ouverture (110a) et en retrait vers un côté arrière ;
un couvercle de porte (6140, 7140) monté sur une surface avant du cadre de porte (6110), disposé pour couvrir la portion d'ouverture (110a) et la portion de logement de module d'affichage (6110b, 7110b), et comportant une région de non-transmission de lumière (143), et une première région de transmission de lumière (141) correspondant à la portion d'ouverture (110a) et une seconde région de transmission de lumière (142) correspondant à la portion de logement de module d'affichage (6110b, 7110b) au sein de la région de non-transmission de lumière (143) ; et
un module d'affichage (6130, 7130) logé dans la portion de logement de module d'affichage (6110b, 7110b), prévu sur une surface arrière du couvercle de porte (6140, 7140), et configuré pour fournir en sortie des informations visuelles à travers la seconde région de transmission de lumière (142), et
le module d'affichage (6130, 7130) comprend :
un cadre de montage (6131, 7131) muni d'une portion de montage d'afficheur (6131a, 7131a) et d'une portion de montage de carte de circuit imprimé (6131d, 7131d) au niveau de ses deux côtés, respectivement ;
un couvercle de PCB (6137, 7137) monté sur le cadre de montage (6131, 7131) pour couvrir la portion de montage de carte de circuit imprimé (6131d, 7131d) ;
un organe d'étanchéité d'afficheur (6133, 7133) disposé entre le cadre de porte (6110) et le cadre de montage (6131, 7131), et formé pour entourer la portion de montage d'afficheur (6131a, 7131a) ; et
un organe d'étanchéité de PCB (6138, 7138) disposé entre le cadre de montage (6131, 7131) et le couvercle de PCB (6137, 7137), et formé pour entourer la portion de montage de carte de circuit imprimé (6131d, 7131d),
dans lequel une rainure de remplissage d'agent d'étanchéité (6111d, 7111d) qui forme un espace à remplir d'agent d'étanchéité pour une adhérence au couvercle de porte (6140, 7140) est prévue sur la surface avant du cadre de porte (6110), de façon à entourer la portion d'ouverture (110a) et la portion de logement de module d'affichage (6110b, 7110b), séparément, et
dans lequel l'organe d'étanchéité d'afficheur (6133, 7133) est situé au sein de la rainure de remplissage d'agent d'étanchéité (6111d, 7111d) qui entoure la portion de logement de module d'affichage (6110b, 7110b).

16. Appareil de traitement de linge selon la revendication 15, dans lequel le cadre de porte (6110) comprend :
une première portion de montage (6111', 7111') formée sur une surface avant du cadre de porte (6110), de façon à monter le couvercle de porte (6140, 7140) ; et
une seconde portion de montage (6111", 7111") en retrait au sein de la première portion de montage (6111', 7111') de façon à monter le cadre de montage (6131, 7131), et formée pour entourer la portion de logement d'afficheur (6110b, 7110b), et
dans lequel le couvercle de porte (6140, 7140) est disposé pour couvrir le cadre de montage (6131, 7131) dans un état où le couvercle de porte (6140, 7140) est monté sur le cadre de porte (6110).

17. Appareil de traitement de linge selon la revendication 15, dans lequel une rainure de logement (6131f, 7111h) formée pour loger une partie de l'organe d'étanchéité d'afficheur (6133, 7133) et entourer un afficheur (6132, 7132) monté sur le cadre de montage (6131, 7131), est formée sur l'un ou l'autre du cadre de montage (6131, 7131) et du cadre de porte (6110), et
dans lequel une autre partie de l'organe d'étanchéité d'afficheur (6133, 7133) est formée pour être mise en saillie depuis la rainure de logement (6131f, 7131f), et mise en contact avec l'autre du cadre de montage (6131, 7131) et du cadre de porte (6110) lorsque le cadre de montage (6131, 7131) est monté sur le cadre de porte (6110).

18. Appareil de traitement de linge selon la revendication 17, dans lequel l'organe d'étanchéité d'afficheur (6133, 7133) est muni d'une pluralité de portions de contact (133a, 133b) mises en contact avec l'autre du cadre de montage (6131, 7131) et du cadre de porte (6110), respectivement, et
la pluralité de portions de contact (133a, 133b) sont disposées pour être séparées l'une de l'autre dans une direction de largeur, et étendues en parallèle suivant une direction de longueur pour former une pluralité de boucles d'étanchéité.

19. Appareil de traitement de linge selon l'une quelconque des revendications 15 à 18, dans lequel l'organe d'étanchéité de PCB (6138, 7138) est muni d'une pluralité de portions de contact (138a, 138b) mises en contact avec le couvercle de PCB (6137, 7137), respectivement, et
la pluralité de portions de contact (138a, 138b) sont disposées pour être séparées l'une de l'autre dans une direction de largeur, et étendues en parallèle suivant une direction de longueur pour former une pluralité de boucles d'étanchéité.

20. Appareil de traitement de linge selon l'une quelconque des revendications 15 à 19, dans lequel le cadre de porte (6110) comprend :
un cadre extérieur (6111, 7111) formé avec la rainure de remplissage d'agent d'étanchéité (6111d, 7111d) à remplir d'agent d'étanchéité pour une adhérence au couvercle de porte (6140, 7140) sur une surface avant ; et
un cadre intérieur (6112, 7112) couplé à un côté arrière du cadre extérieur (6111, 7111).

21. Appareil de traitement de linge selon la revendication 20, dans lequel le cadre de montage (6131, 7131) est configuré pour être monté sur une surface avant du cadre extérieur (6111, 7111) et couvert par le couvercle de porte (6140, 7140), et
l'agent d'étanchéité ayant rempli la rainure de remplissage d'agent d'étanchéité (6111d, 7111d) est configuré pour entourer l'organe d'étanchéité d'afficheur (6133, 7133).

22. Appareil de traitement de linge (1), comprenant :
un corps (20) muni d'une entrée de linge (20a) ; et
une porte (1010) configurée pour ouvrir et fermer l'entrée de linge (20a),
dans lequel la porte (1010) comprend :
un cadre de porte (1110) ayant une portion d'ouverture (1110a) face à l'entrée de linge (20a) lorsque la porte (1010) est fermée et une portion de logement de module d'affichage (11 10b) espacée de la portion d'ouverture (1110a) et en retrait vers un côté arrière ;
un couvercle de porte (140) monté sur une surface avant du cadre de porte (1110), disposé pour couvrir la portion d'ouverture (1110a) et la portion de logement de module d'affichage (1110b), et comportant une région de non-transmission de lumière (1143), et une première région de transmission de lumière (1141) correspondant à la portion d'ouverture (1110a) et une seconde région de transmission de lumière (1142) correspondant à la portion de logement de module d'affichage (1110b) au sein de la région de non-transmission de lumière (1143) ; et un module d'affichage (1130) logé dans la portion de logement de module d'affichage (1110b), prévu sur une surface arrière du couvercle de porte (1110a), et configuré pour fournir en sortie des informations visuelles à travers la seconde région de transmission de lumière (1142), et
un organe d'étanchéité d'afficheur (1133) est configuré pour entourer un afficheur (1132) prévu dans le module d'affichage (1130) entre le couvercle de porte (1140) et le module d'affichage (1130),
dans lequel une rainure de remplissage d'agent d'étanchéité (1111d) qui forme un espace à remplir d'agent d'étanchéité pour une adhérence avec un couvercle de porte (1140) est prévue sur une surface avant du cadre de porte (1110), de façon à entourer la portion d'ouverture (1110a) et la portion de logement de module d'affichage (1110b), séparément, et
dans lequel l'organe d'étanchéité d'afficheur (1133) est situé au sein de la rainure de remplissage d'agent d'étanchéité (1111d) qui entoure la portion de logement de module d'affichage (1110b).
